# EUROPEAN PATENT APPLICATION

(11) **EP 4 318 550 A1**
(43) Date of publication of application: **07.02.2024**
(21) Application number: 22781050.4
(22) Date of filing: 30.03.2022
(51) Int. Cl.: H01L 21/02, H01L 21/683

(54) **BONDING SYSTEM AND BONDING METHOD**

(30) Priority: 31.03.2021 JP 2021059944
(71) Applicant: Bondtech Co., Ltd., Minami-ku Kyoto-shi Kyoto 601-8366 (JP)
(72) Inventor: YAMAUCHI, Akira, Kyoto-shi, Kyoto 601-8366 (JP)
(74) Representative: Rüger Abel Patentanwälte PartGmbB
(86) International application number: PCT/JP2022/015840
(87) International publication number: WO 2022/210839

(57) **Abstract**

A bonding system is a bonding system that bonds two substrates and includes: a bonder (1) that executes a positioning process of performing positioning of the two substrates under reduced pressure, and then executes a contact process of bringing the two substrates into contact under reduced pressure; and a conveying device (84) that conveys, to the bonder (1), the two substrates to be bonded to each other. Then, the bonder (1) executes the positioning process and the contact process mentioned earlier in a state where the conveying device (84) is separated from the bonder (1).

## Description

### Technical Field

The present invention relates to a bonding system and a bonding method.

### Background Art

There has been proposed a bonder that measures a position gap amount of two objects to be bonded in a state where one of the objects to be bonded is held on a stage and the other is held on a head, aligns the objects to be bonded based on the position gap amount, and then bonds the objects to be bonded to each other (e.g., refer to Patent Literature 1).

### Citation List

### Patent Literature

Patent Literature 1: JP 2011-066287 A

### Summary of Invention

### Technical Problem

The bonder described in Patent Literature 1 is generally provided as one bonding system combined together with an introduction port for receiving an object to be bonded and a conveying device for conveying the object to be bonded placed on the introduction port into the bonder. In this case, when vibration generated in the conveying device is transmitted to the bonder, the head vibrates relative to the stage in the bonder, and there is a possibility of failing to accurately measure the relative position gap amount between the objects to be bonded. When the measurement accuracy of the position gap amount between the objects to be bonded is low, it becomes difficult to bond the objects to be bonded with high position accuracy.

The present invention has been made in view of the above circumstances, and an object is to provide a bonding system and a bonding method that can bond objects to be bonded with high position accuracy.

### Solution to Problem

In order to achieve the above object, a bonding system according to the present invention is
a bonding system that bonds two objects to be bonded, the bonding system including:
a bonder that executes a positioning process of performing positioning of the two objects to be bonded under reduced pressure, and then executes a contact process of bringing the two objects to be bonded into contact under reduced pressure; and
a conveying device that conveys, to the bonder, the two objects to be bonded,
wherein the bonder executes the positioning process and the contact process in a state where the conveying device is separated from the bonder.

A bonding method according to the present invention as viewed from another viewpoint is
a bonding method for bonding two objects to be bonded, the bonding method including:
a conveying process in which a conveying device conveys, to the bonder, the two objects to be bonded in a state of being in contact with the bonder;
a detaching process in which the conveying device is brought into a state of being detached from the bonder and separated from the bonder;
a positioning process in which the bonder performs positioning of one of the two objects to be bonded with respect to another under reduced pressure in a state where the conveying device is separated from the bonder; and
a contact process in which the bonder brings the two objects to be bonded into contact under reduced pressure in a state where the conveying device is separated from the bonder.

### Advantageous Effects of Invention

According to the present invention, the bonder executes the positioning process of performing positioning of two objects to be bonded under reduced pressure in a state where the conveying device is separated from the bonder, and then executes the contact process of bringing the two objects to be bonded into contact under reduced pressure. Due to this, when the bonder executes the positioning process and the contact process, the influence of an error in the position gap amount due to vibration generated in the conveying device is reduced, and therefore the two objects to be bonded can be bonded to each other with high position accuracy accordingly.

### Brief Description of Drawings

FIG. 1 is a schematic configuration diagram of a substrate bonding system according to an embodiment of the present invention.
FIG. 2A is a schematic cross-sectional view of a case where a bonder and a seal member of a part of a conveying device according to the embodiment are in a second state.
FIG. 2B is a schematic cross-sectional view of a case where the bonder and the seal member of a part of the conveying device according to the embodiment are in a first state.
FIG. 3 is a schematic view of a seal drive unit according to the embodiment.
FIG. 4 is a schematic front view of an activation treatment device according to the embodiment.
FIG. 5 is a schematic front view of the bonder according to the embodiment.
FIG. 6A is a view illustrating two alignment marks provided on one of two substrates to be bonded.
FIG. 6B is a view illustrating two alignment marks provided on the other of the two substrates to be bonded.
FIG. 7A is a schematic view illustrating a state where the alignment marks are shifted from each other.
FIG. 7B is a schematic view illustrating a state where the alignment marks are shifted from each other.
FIG. 8 is a schematic view of a part of the bonder according to the embodiment.
FIG. 9 is a flowchart showing a flow of a bonding method executed by the bonding system according to the embodiment.
FIG. 10A is a view illustrating a state where a substrate is conveyed by the conveying device of the bonding system according to the embodiment.
FIG. 10B is a view illustrating a state where the substrate is delivered from the conveying device of the bonding system according to the embodiment to a load lock unit.
FIG. 11A is a view illustrating a state where the substrate is delivered from the load lock unit of the bonding system according to the embodiment to the conveying device.
FIG. 11B is a view illustrating a state where the substrate is delivered from the conveying device of the bonding system according to the embodiment to the activation treatment device.
FIG. 12A is a view illustrating a state where the substrate is delivered from the conveying device of the bonding system according to the embodiment to the load lock unit.
FIG. 12B is a view illustrating a state where the substrate is delivered from the load lock unit of the bonding system according to the embodiment to the conveying device.
FIG. 13A is a view illustrating a state where the substrate is delivered from the conveying device of the bonding system according to the embodiment to a cleaning device.
FIG. 13B is a view illustrating a state where the substrate is delivered from the cleaning device of the bonding system according to the embodiment to the conveying device.
FIG. 14A is a view illustrating a state where the substrate is delivered from the conveying device of the bonding system according to the embodiment to the load lock unit.
FIG. 14B is a view illustrating a state where the substrate is delivered from the load lock unit of the bonding system according to the embodiment to the conveying device.
FIG. 15A is a view illustrating a state where the seal member of the bonding system according to the embodiment is brought into the first state.
FIG. 15B is a view illustrating a state where the substrate is conveyed to the bonder by the conveying device of the bonding system according to the embodiment.
FIG. 16 is a view illustrating frequency spectra of vibration amplitudes in a case where a plate drive unit of a vibration isolation unit according to the embodiment is operated and in a case where the plate drive unit is stopped.
FIG. 17 is a schematic front view of a bonder according to a modification.
FIG. 18 is a schematic cross-sectional view illustrating the bonder and a part of a conveying device according to the modification.
FIG. 19 is a schematic front view of a part of the bonder and the conveying device according to the modification.
FIG. 20 is a schematic front view of the bonder according to the modification.
FIG. 21 is a flowchart showing a flow of a bonding method executed by the bonding system according to the modification.

### Description of Embodiments

Hereinafter, a bonding system according to an embodiment of the present invention will be described with reference to the drawings. The bonding system according to the present embodiment is a bonding system that bonds two objects to be bonded. This bonding system includes a bonder and a conveying device. The bonder is installed on a first frame, executes a positioning process of performing positioning of two objects to be bonded under reduced pressure, and then executes a contact process of bringing the two objects to be bonded into contact under reduced pressure. The conveying device is installed on a second frame different from the first frame and arranged apart from the first frame, and conveys, to the bonder, two objects to be bonded. Then, the bonder executes the positioning process and the contact process mentioned earlier in a state where the conveying device is separated from the bonder. The bonding system includes an activation treatment device and a cleaning device, and before conveying, to the bonder, two objects to be bonded, the activation treatment device performs an activation treatment for bonding surfaces of the two objects to be bonded, and then the cleaning device cleans the bonding surfaces of the two objects to be bonded.

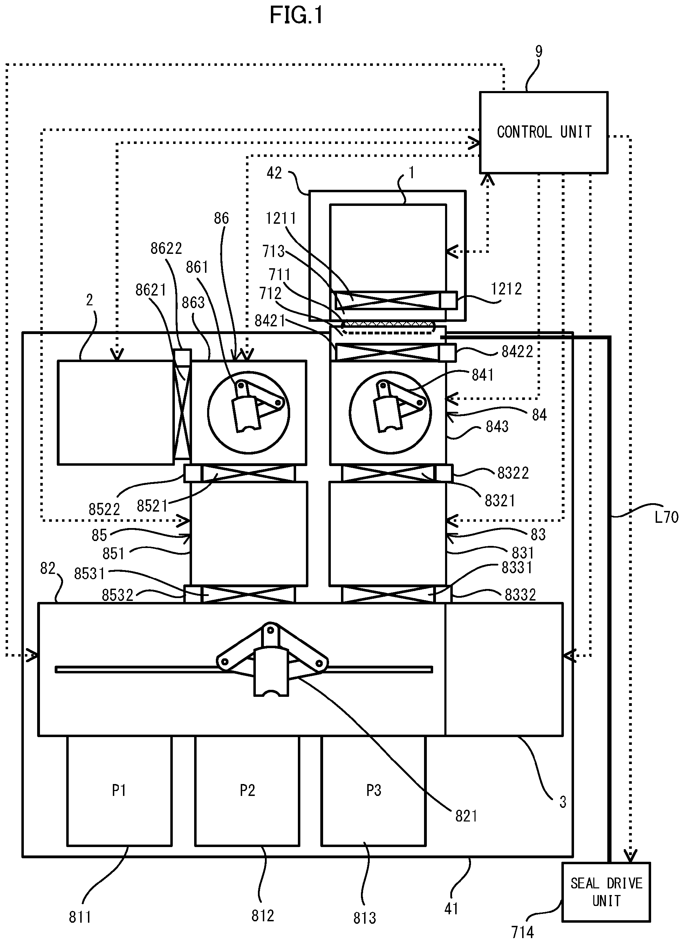

As illustrated in FIG. 1, the bonding system according to the present embodiment includes introduction ports 811 and 812, an extraction port 813, conveying devices 82, 84, and 86, a cleaning device 3, an activation treatment device 2, a bonder 1, load lock units 83 and 85, and a control unit 9 that controls operations of the conveying devices 82, 84, and 86, the cleaning device 3, the activation treatment device 2, the bonder 1, and the load lock units 83 and 85. The bonding system includes a first frame 42 supporting the bonder 1 and a second frame 41 different from the first frame 42 and arranged apart from the first frame 42. The second frame 41 collectively supports the introduction ports 811 and 812, the extraction port 813, the conveying devices 82, 84, and 86, the cleaning device 3, the activation treatment device 2, and the load lock units 83 and 85. The first frame 42 is, for example, an aseismic frame, and the second frame 41 is, for example, a frame is provided with a grating vertically above.

The conveying device 82 includes a conveying robot 821 having an arm provided with a holding portion that holds a substrate at a tip end part. The conveying robot 821 is movable along the arrangement direction of the introduction ports 811 and 812 and the extraction port 813, and can change the orientation of the tip end part of the arm by turning. The conveying device 82 is provided with a high efficiency particulate air (HEPA) filter (not illustrated). Due to this, the inside of the conveying device 82 is in an atmospheric pressure environment with extremely few particles.

The cleaning device 3 cleans a conveyed substrate while discharging water, a cleaning liquid, or N₂ gas toward the substrate. The cleaning device 3 has a stage (not illustrated) supporting the substrate, a rotation drive unit (not illustrated) that rotates the stage in a plane orthogonal in the vertical direction, and a cleaning nozzle (not illustrated) that discharges water, a cleaning liquid, or N₂ gas having been applied with ultrasonic waves or megasonic vibrations. Then, the cleaning device 3 cleans the entire surfaces of the bonding surfaces of substrates W1 and W2 by rotating the stage while spraying, to the bonding surfaces of the substrates, water to which ultrasonic waves are applied from the cleaning nozzle while swinging the cleaning nozzle in the radial direction of the substrates W1 and W2. Then, the cleaning device 3 spin-dries the substrates W1 and W2 by rotating the stage in a state of stopping the discharge of water by the cleaning nozzle. Similarly to the conveying device 82, the cleaning device 3 is also provided with a HEPA filter (not illustrated).

The load lock unit 83 includes a chamber 831, an exhaust pipe (not illustrated) communicating with the inside of the chamber 831, a vacuum pump (not illustrated) that discharges gas in the chamber 831 through the exhaust pipe, and an exhaust valve (not illustrated) inserted in the exhaust pipe. The load lock unit 83 reduces (decompresses) the gas pressure in the chamber 831 by discharging the gas in the chamber 831 to the outside of the chamber 831 through the exhaust pipe by operating the vacuum pump by bringing the exhaust valve into an open state. The load lock unit 83 includes a gate 8331 arranged on the conveying device 82 side in the chamber 831, a gate 8321 arranged on the conveying device 84 side in the chamber 831, and gate drive units 8332 and 8322 that drive opening and closing of the gates 8331 and 8321, respectively. The load lock unit 83 includes an alignment mechanism (not illustrated) that adjusts attitudes of the substrates W1 and W2 in the chamber 831. The gates 8331 and 8321 are provided so as to cover an opening (not illustrated) penetrating the chamber 831 on the conveying device 82 side and an opening (not illustrated) penetrating on the conveying device 84 side, respectively. The load lock unit 83 includes the chamber 831, the exhaust pipe (not illustrated) communicating with the inside of the chamber 831, the vacuum pump (not illustrated) that discharges gas in the chamber 831 through the exhaust pipe, and the exhaust valve (not illustrated) inserted in the exhaust pipe. The load lock unit 83 reduces (decompresses) the gas pressure in the chamber 831 by discharging the gas in the chamber 831 to the outside of the chamber 831 through the exhaust pipe by operating the vacuum pump by bringing the exhaust valve into an open state. The load lock unit 83 includes the gate 8331 arranged on the conveying device 82 side in the chamber 831, the gate 8321 arranged on the conveying device 84 side in the chamber 831, and the gate drive units 8332 and 8322 that drive opening and closing of the gates 8331 and 8321, respectively. The gate drive units 8332 and 8322 drive opening and closing of the gates 8331 and 8321 based on a control signal input from the control unit 9. Similarly to the load lock unit 83, the load lock unit 85 includes a chamber 851, an exhaust pipe (not illustrated), a vacuum pump (not illustrated), and an exhaust valve (not illustrated). The load lock unit 85 includes a gate 8531 arranged on the conveying device 82 side in the chamber 851, a gate 8521 arranged on the conveying device 86 side in the chamber 851, and gate drive units 8532 and 8522 that drive opening and closing of the gates 8531 and 8521, respectively. The gate drive units 8532 and 8522 drive opening and closing of the gates 8531 and 8521 based on a control signal input from the control unit 9.

The conveying device 84 is a conveying means including a chamber 843, an exhaust pipe (not illustrated) communicating with the inside of the chamber 843, a vacuum pump (not illustrated) that discharges gas in the chamber 831 through the exhaust pipe, an exhaust valve (not illustrated) inserted into the exhaust pipe, and a conveying robot 841 that conveys the substrates W1 and W2. The conveying device 84 maintains the inside of the chamber 831 in a depressurized state by discharging the gas in the chamber 831 to the outside of the chamber 831 through the exhaust pipe by operating the vacuum pump by bringing the exhaust valve into an open state. The conveying device 84 includes a gate 8421 arranged on the bonder 1 side in the chamber 843, and a gate drive unit 8422 that drives opening and closing of the gate 8421. The chamber 843 is a second chamber having an opening (not illustrated) penetrating the bonder 1 side and an opening (not illustrated) penetrating the load lock unit 83 side. The gate 8421 is a second gate provided in a part of a chamber 841 so as to cover an opening (not illustrated) penetrating on the bonder 1 side in the chamber 841. The gate drive unit 8421 is a second gate drive unit that brings the gate 8421 into an open state when the conveying robot 841 conveys the substrates W1 and W2 into the bonder 1. An opening penetrating on the load lock unit 83 side in the chamber 841 is covered with the gate 8321 of the load lock unit 83. The conveying robot 841 has an arm provided with a holding portion that holds a substrate at a tip end part, and can change the orientation of the tip end part of the arm by turning. The holding portion is, for example, an electrostatic chuck, and adsorbs and holds sides of the substrates W1 and W2 opposite to the bonding surface side.

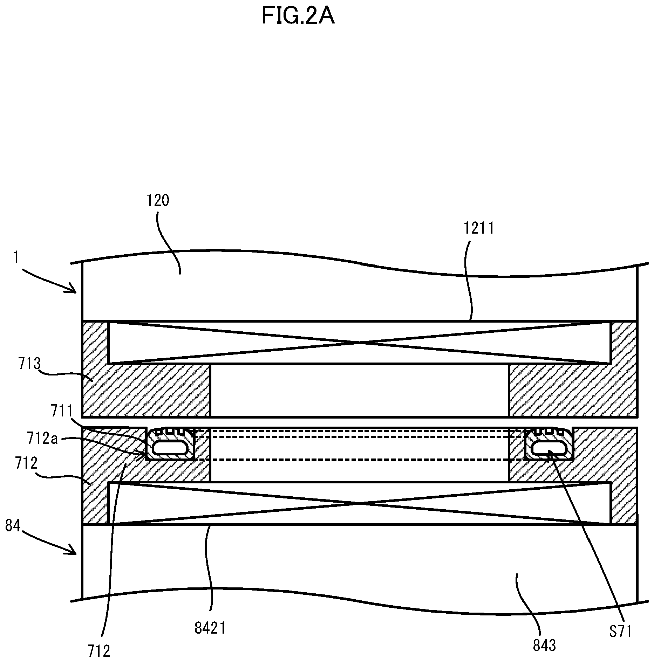

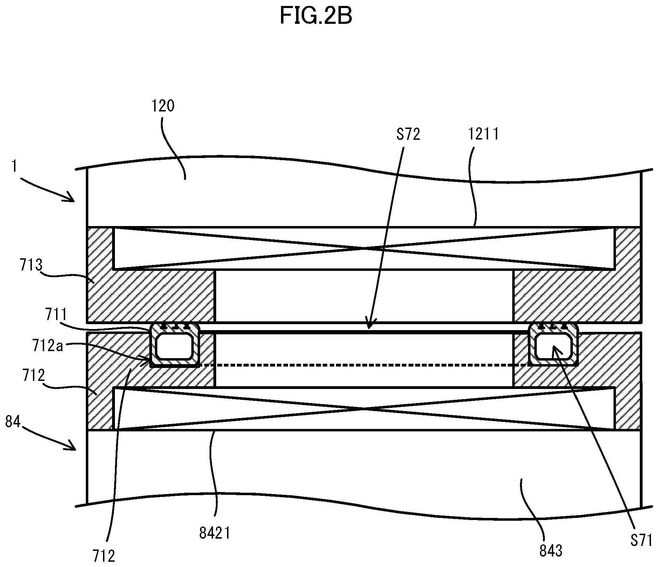

As illustrated in FIG. 2A, the conveying device 84 includes a frame body 712 provided so as to surround the gate 8421 outside the chamber 843, and a seal member 711 that is annular and is arranged over the entire circumference of the frame body 712 on a side of the frame body 712 facing a frame body 713 of the bonder 1 described later. The frame body 712 is a second frame body facing the frame body 713 and arranged apart from the frame body 713. A groove 712a into which the seal member 711 is fitted is formed over the entire circumference on a surface side of the frame body 712 facing the frame body 713. The seal member 711 is formed in a tubular shape from, for example, synthetic rubber, and has a filling region S71 inside which is filled with a fluid such as air or a gas. The seal member 711 is expanded by filling the filling region S71 inside thereof with the fluid, and as illustrated in FIG. 2B, is brought into the first state of being in close contact with the frame body 713 to seal a region S72 between the frame body 713 and the frame body 712. On the other hand, the seal member 711 is contracted by discharging the fluid in the filling region S72 inside thereof, and is brought into the second state of being separated from the frame body 713.

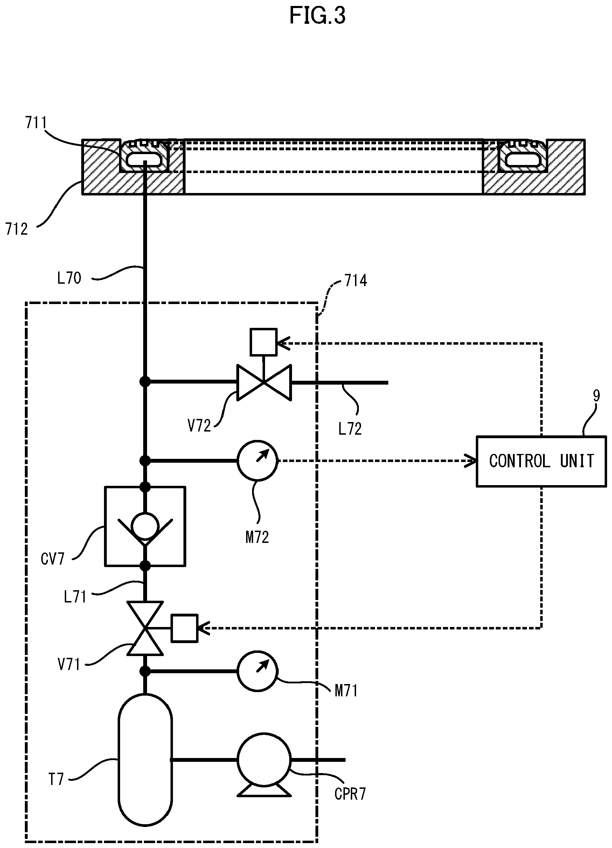

Furthermore, the conveying device 84 includes a seal drive unit 714 that fills the filling region S71 of the seal member 711 with gas or discharges the gas filled in the filling region S71 so that the seal member 711 is brought into any one of the first state and the second state mentioned earlier. For example, as illustrated in FIG. 3, the seal drive unit 714 includes an intake/discharge pipe L70 communicating with the filling region S71 inside the seal member 711 at one end part, a check valve CV7 connected to the other end part of the intake/discharge pipe L70, and an introduction pipe L71 having one end part connected to the check valve CV7 and the other end part connected to a tank T7. The seal drive unit 714 includes a compressor CPR7 that supplies the tank T7 with gas, a solenoid valve V71 inserted into the introduction pipe L71, and a pressure gauge M71 that measures the pressure in the introduction pipe L71. Furthermore, the seal drive unit 714 includes a discharge pipe L72 connected to the intake/discharge pipe L70, a solenoid valve V72 inserted into the discharge pipe L72, and a pressure gauge M72 that measures the pressure of the intake/discharge pipe L70. Here, the compressor CPR7 supplies the tank T7 with gas so that the pressure of the pressure gauge M71 is maintained at a preset pressure. The control unit 9 controls the solenoid valves V71 and V72 based on the pressure measured by the pressure gauge M72. Specifically, the control unit 9 changes the seal member 711 from the second state to the first state by filling the filling region S71 of the seal member 711 with gas by bringing the solenoid valve V72 into a close state and bringing the solenoid valve V71 into an open state. On the other hand, the control unit 9 changes the seal member 711 from the first state to the second state by discharging the gas filled in the filling region S71 of the seal member 711 to the outside of the seal member 711 by bringing the solenoid valve V71 into a close state and bringing the solenoid valve V72 into an open state.

Returning to FIG. 1, similarly to the conveying device 84, the conveying device 86 includes a chamber 863, an exhaust pipe (not illustrated), a vacuum pump (not illustrated), an exhaust valve (not illustrated), and a conveying robot 861. The conveying device 86 includes a gate 8621 arranged on the activation treatment device 2 side in the chamber 863, and a gate drive unit 8622 that drives opening and closing of the gate 8621. The chamber 863 has an opening (not illustrated) penetrating on the activation treatment device 2 side and an opening (not illustrated) penetrating on the load lock unit 85 side. The gate 8621 is arranged so as to cover an opening (not illustrated) penetrating on the activation treatment device 2 side in the chamber 861. The opening penetrating on the load lock unit 85 side in the chamber 861 is covered with the gate 8521 of the load lock unit 85. Similarly to the conveying robot 841, the conveying robot 861 has an arm provided with a holding portion that holds a substrate at a tip end part, and can change the orientation of the tip end part of the arm by turning. The holding portion is, for example, an electrostatic chuck, and adsorbs and holds sides of the substrates W1 and W2 opposite to the bonding surface side.

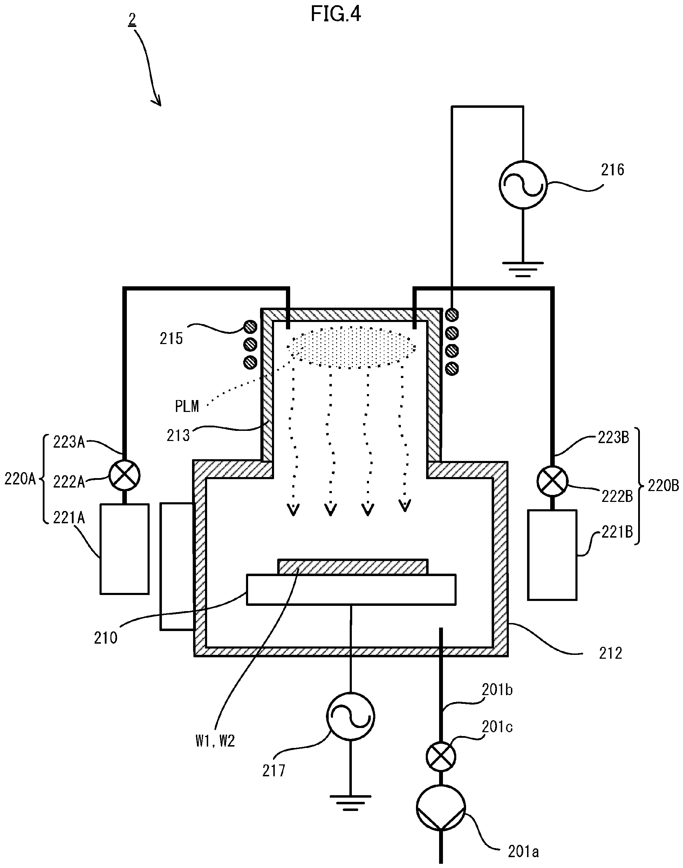

The activation treatment device 2 performs activation treatment of activating the bonding surface of the substrate by performing at least one of reactive ion etching using nitrogen gas and irradiation with nitrogen radicals with respect to the bonding surface. The activation treatment device 2 is a device that generates inductively coupled plasma (ICP), and, as illustrated in FIG. 4, includes a stage 210, a treatment chamber 212, a plasma chamber 213, an induction coil 215 wound outside the plasma chamber 213, and a high-frequency power source 216 that supplies the induction coil 215 with a high-frequency current. The plasma chamber 213 is formed of, for example, quartz glass. The activation treatment device 2 includes a nitrogen gas supply unit 220A and an oxygen gas supply unit 220B. The nitrogen gas supply unit 220A includes a nitrogen gas storage unit 221A, a supply valve 222A, and a supply pipe 223A. The oxygen gas supply unit 220B includes an oxygen gas storage unit 221B, a supply valve 222B, and a supply pipe 223B. The substrates W1 and W2 are placed on the stage 210. The treatment chamber 212 communicates with the inside of the plasma chamber 213. The treatment chamber 212 is connected to the vacuum pump 201a via an exhaust pipe 201b and an exhaust valve 201c. The activation treatment device 2 brings the exhaust valve 201c into an open state and operates the vacuum pump 201a to discharge the gas in the treatment chamber 212 to the outside of the treatment chamber 212 through an exhaust pipe 202b, thereby reducing (decompressing) the gas pressure in the treatment chamber 212.

As the high-frequency power source 216, one that supplies a high-frequency current of, for example, 27 MHz to the induction coil 215 can be adopted. Then, when a high-frequency current is supplied to the induction coil 215 in a state where the N₂ gas is introduced into the plasma chamber 213, plasma PLM is formed in the plasma chamber 213. Here, since ions contained in the plasma are trapped in the plasma chamber 213 by the induction coil 215, a configuration may be adopted in which no trap plate is in a part between the plasma chamber 213 and the treatment chamber 212. A plasma generation source that generates the plasma PLM in the plasma chamber 213 and supplies N₂ radicals in the plasma to the bonding surfaces of the substrates W1 and W2 supported by the stage 210 is configured from the induction coil 215, the high-frequency power source 216, and the nitrogen gas supply unit 220A. Note that, here, an example in which the activation treatment device 2 is a device that generates ICP including the induction coil 215 and the high-frequency power source 216 has been described, but the activation treatment device 2 is not limited to this, and instead, the activation treatment device 2 may be a device that generates capacitively coupled plasma (CCP) including a flat-plate electrode arranged outside the plasma chamber 213, a high-frequency power source electrically connected to the flat-plate electrode, and a trap plate arranged in a part between the plasma chamber 213 and the treatment chamber 212 to trap ions in the plasma. In this case, as the high-frequency power source, one that applies a high-frequency bias of, for example, 27 MHz can be adopted. Then, the power supplied from the high-frequency power source into the plasma chamber is set to, for example, 250 W. A bias application unit 217 is a high-frequency power source that applies a high-frequency bias to the substrates W1 and W2 supported by the stage 210. As this bias application unit 217, one that generates a high-frequency bias of, for example, 13.56 MHz can be adopted. In this manner, by applying the high-frequency bias to the substrates W1 and W2 by the bias application unit 217, a sheath region in which ions having kinetic energy repeatedly collide with the substrates W1 and W2 is generated in the vicinity of the bonding surfaces of the substrates W1 and W2. Then, the bonding surfaces of the substrates W1 and W2 are etched by ions having kinetic energy existing in this sheath region.

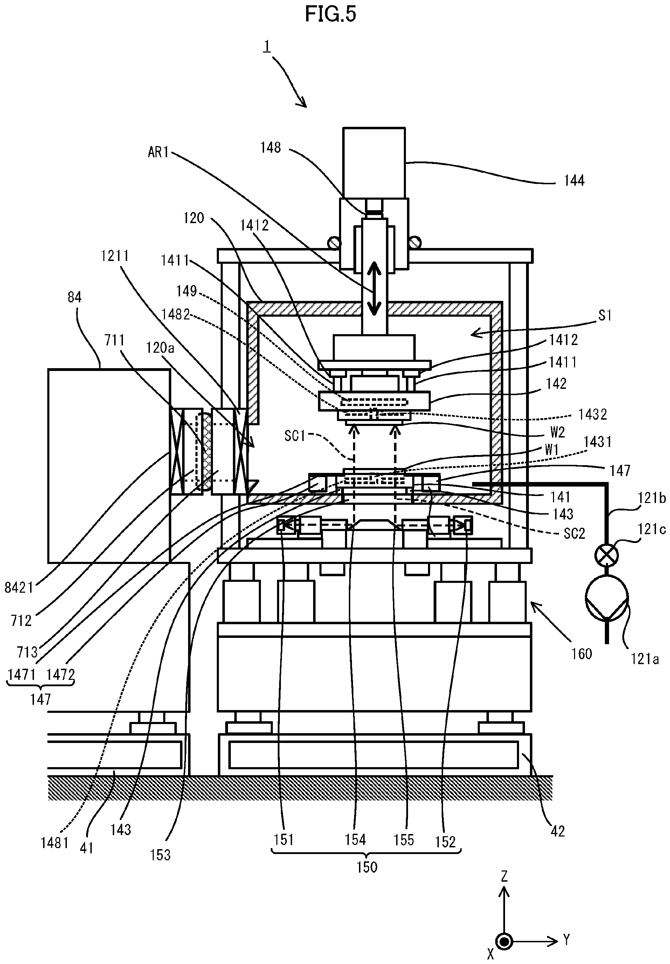

Returning to FIG. 1, the bonder 1 bonds the substrates W1 and W2 whose bonding surfaces have been cleaned by the cleaning device 3 after being subjected to the activation treatment in the activation treatment device 2. As illustrated in FIG. 5, the bonder 1 includes a chamber 120, a stage 141, a head 142, a stage drive unit 143, a head drive unit 144, a support mechanism 147, substrate heating units 1481 and 1481, a position measurement unit 150, and a vibration isolation unit 160. The following description will appropriately be made with the ±Z direction in FIG. 5 as an up-down direction, and the XY direction as a horizontal direction. The stage 141 and the head 142 are arranged in the chamber 120 so as to face each other in the vertical direction and so that the stage 141 is positioned on the -Z direction side relative to the head 142. The stage 141 is a first holding portion that holds the substrate W1 on the surface on the +Z direction side, and the head 142 is a second holding portion that holds the substrate W2 on the surface on the -Z direction side. The stage 141 and the head 142 are made of a translucent material such as glass having translucency, for example. The stage 141 and the head 142 are respectively provided with an electrostatic chuck (not illustrated) that holds the substrates W1 and W2, and pressing mechanisms 1431 and 1432 that press central parts of the substrates W1 and W2.

The chamber 120 is a first chamber that maintains a region S1 where the substrates W1 and W2 are arranged at a degree of vacuum equal to or higher than a preset reference degree of vacuum. The chamber 120 is connected to a vacuum pump 121a via an exhaust pipe 121b and an exhaust valve 121c. When the exhaust valve 121c is brought into an open state and the vacuum pump 121a is operated, the gas in the chamber 120 is discharged to the outside of the chamber 120 through the exhaust pipe 121b, and the inside of the chamber 120 is maintained in a decompressed atmosphere. By varying the open/close amount of the exhaust valve 121c to adjust the exhaust amount, it is possible to adjust the gas pressure (degree of vacuum) in the chamber 120. A part of the chamber 120 is provided with a window portion 153 used for measuring a relative position between the substrates W1 and W2 by the position measurement unit 150. Apart of the chamber 120 is provided with an opening 120a for allowing the substrates W1 and W2 to enter and exit. The gate 1211 is provided so as to cover the opening 120a of the chamber 120.

The stage drive unit 143 is a holding portion drive unit that can move the stage 141 in the XY direction and rotating the stage around the Z axis. By the stage drive unit 143 moving the stage 141 relative to the head 142 in the X direction, the Y direction, and the rotation direction around the Z axis, it becomes possible to align the substrate W1 held by the stage 141 and the substrate W2 held by the head 142.

The head drive unit 144 raises and lowers the head 142 vertically upward or vertically downward (see an arrow AR1 in FIG. 5). The head drive unit 144 includes a piezo actuator 1411 for adjusting the inclination of the head 142 with respect to the stage 141, and a pressure sensor 1412 for measuring the pressure applied to the head 142. For example, in a case where the head 142 has a circular shape in plan view, the pressure sensors 1412 are arranged at three locations in the circumferential direction of the head 142.

By moving the head 142 in the vertical direction, the head drive unit 144 brings the stage 141 and the head 142 close to each other or move the head 142 away from the stage 141. When the head drive unit 144 moves the head 142 vertically downward, the substrate W1 held by the stage 141 and the substrate W2 held by the head 142 come into contact with each other. Then, when the head drive unit 144 applies a drive force in a direction approaching the stage 141 with respect to the head 142 in a state where the substrates W1 and W2 are in contact with each other, the substrate W2 is pressed against the substrate W1. The head drive unit 144 is provided with a pressure sensor 148 that measures a drive force applied by the head drive unit 144 in a direction approaching the stage 141 with respect to the head 142. The pressure applied on the bonding surfaces of the substrates W1 and W2 when the substrate W2 is pressed against the substrate W1 by the head drive unit 144 can be detected from the measurement value of the pressure sensor 148. The pressure sensor 148 includes, for example, a load cell.

The support mechanism 147 receives the substrates W1 and W2 conveyed into the chamber 120. The support mechanism 147 includes a support member 1471 that supports the substrates W1 and W2, and a support member drive unit 1472 that raises and lowers the support member 1471. The support member 1472 has a substantially L shape, and has a tip end part extending to a step portion (not illustrated) formed in a peripheral part of the stage 141. For example, three support mechanisms 147 are provided, and in this case, the support member 1471 supports three locations in the peripheral parts of the substrates W1 and W2. A projection (not illustrated) that supports the substrates W1 and W2 at the tip end part may be arranged at the tip end part of the support member 1471. Then, the support mechanism 147 lifts the substrates W1 and W2 by driving the support member 1471 in the +Z direction in a state where the tip end part of the support member 1471 abuts on the peripheral parts of the substrates W1 and W2 placed on the stage 141. This support mechanism 147 is fixed to the stage 141 and moves together with the stage 141.

The position measurement unit 150 measures the position gap amount between the substrate W1 and the substrate W2 in a direction (XY direction, rotation direction around Z axis) orthogonal to the vertical direction. The position measurement unit 150 includes a first imaging unit 151, a second imaging unit 152, and mirrors 154 and 155. The first imaging unit 151 and the second imaging unit 152 are arranged on the opposite side of the side holding the substrate W1 in the stage 141. Each of the first imaging unit 151 and the second imaging unit 152 includes an imaging element (not illustrated) and a coaxial illumination system (not illustrated). As the light source of the coaxial illumination system, a light source that emits light (e.g., infrared light) passing through the substrates W1 and W2, the stage 141, and the window portion 153 provided in the chamber 120 is used.

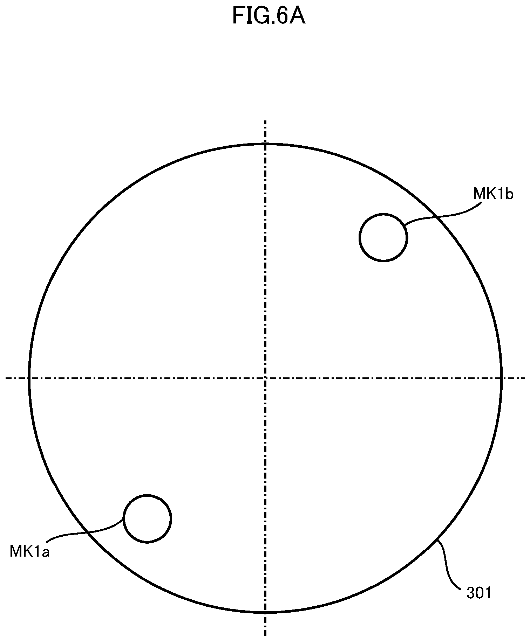

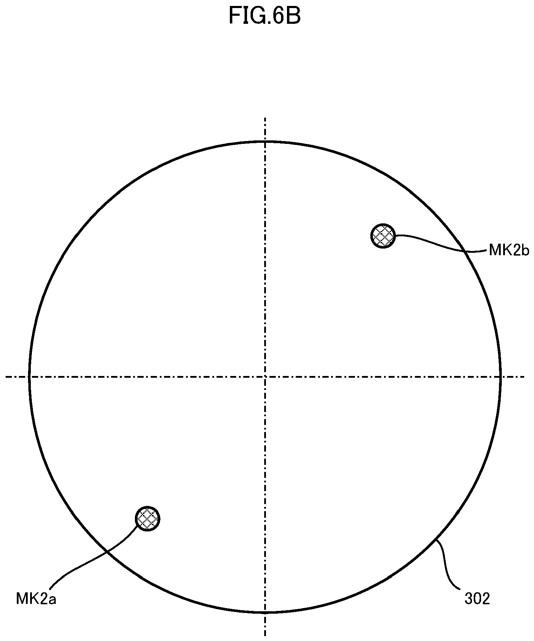

For example, as illustrated in FIGS. 6A and 6B, the substrate W1 is provided with two alignment marks MK1a and MK1b, and the substrate W2 is provided with two alignment marks MK2a and MK2b. The bonder 1 executes position adjustment operation (alignment operation) of both the substrates W1 and W2 while recognizing the positions of the alignment marks MK1a, MK1b, MK2a, and MK2b provided on the substrates W1 and W2 by the position measurement unit 150. More specifically, the bonder 1 first executes a rough alignment operation of the substrates W1 and W2 while recognizing the alignment marks MK1a, MK1b, MK2a, and MK2b provided on the substrates W1 and W2 by the position measurement unit 150, and causes the two substrates W1 and W2 to face each other. Thereafter, the bonder 1 executes more precise alignment operation (fine alignment operation) while simultaneously recognizing the alignment marks MK1a, MK2a, MK1b, and MK2b provided on the two substrates W1 and W2 by the position measurement unit 500.

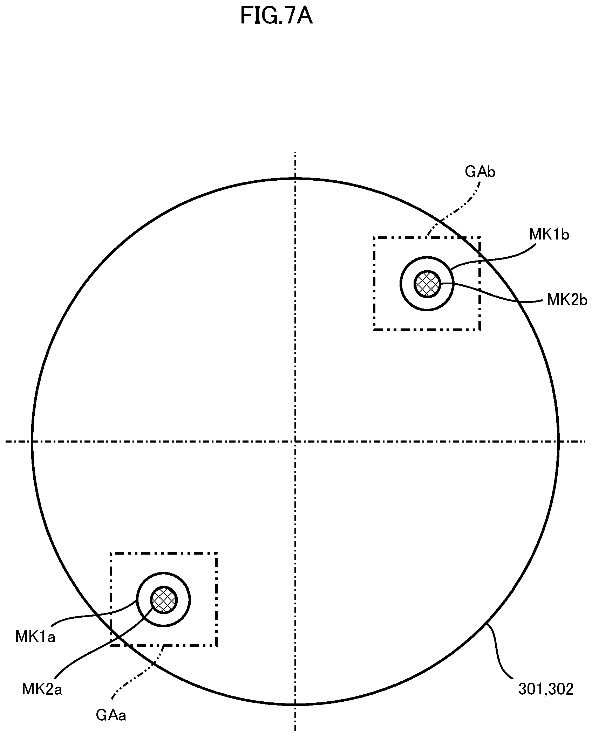

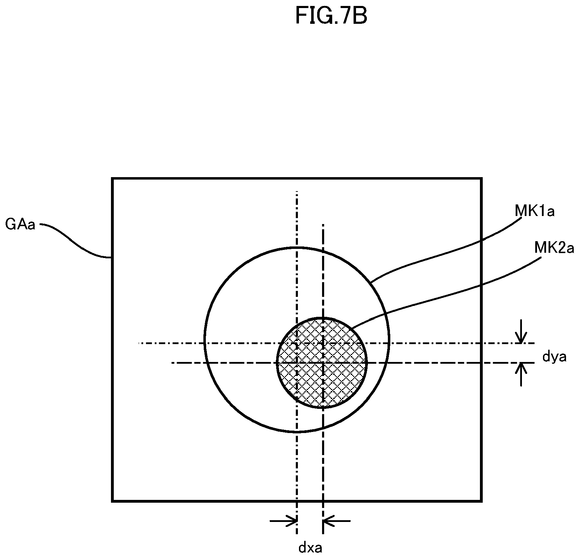

Here, as indicated by broken line arrows SC1 and SC2 in FIG. 5, the light emitted from the light source of the coaxial illumination system of the first imaging unit 151 is reflected by the mirror 154, travels upward, and passes through the window portion 153 and a part or the entirety of the substrates W1 and W2. The light having passed through a part or the entirety of the substrates W1 and W2 is reflected by the alignment marks MK1a and MK2a of the substrates W1 and W2, travels downward, passes through the window portion 153, is reflected by the mirror 154, and enters the imaging element of the first imaging unit 151. The light emitted from the light source of the coaxial illumination system of the second imaging unit 502 is reflected by the mirror 155, travels upward, and passes through the window portion 153 and a part or the entirety of the substrates W1 and W2. The light having passed through a part or the entirety of the substrates W1 and W2 is reflected by the alignment marks MK1a and MK2a of the substrates W1 and W2, travels downward, passes through the window portion 153, is reflected by the mirror 155, and enters the imaging element of the second imaging unit 152. In this manner, as illustrated in FIGS. 7A and 7B, the position measurement unit 150 acquires a photographed image GAa including the alignment marks MK1a and MK2a of the two substrates W1 and W2 and a photographed image GAb including the alignment marks MK1b and MK2b of the two substrates W1 and W2. Note that the photographing operation of the photographed image GAa by the first imaging unit 151 and the photographing operation of the photographed image GAb by the second imaging unit 152 are executed substantially simultaneously. A light source may be provided in the head 142, and light from the light source may be introduced into the first imaging unit 151 and the second imaging unit 152 from the head 142 side.

Returning to FIG. 5, the substrate heating units 1481 and 1482 are, for example, electric heaters, and are provided on the stage 141 and the head 142, respectively. The substrate heating units 1481 and 1482 heat the substrates W1 and W2 by transferring heat to the substrates W1 and W2 held by the stage 141 and the head 142. By adjusting the heat generation amount of the substrate heating units 1481 and 1482, it is possible to adjust the temperatures of the substrates W1 and W2 and the bonding surface thereof. The substrate heating units 1481 and 1482 are connected to a heating unit drive unit (not illustrated), and by supplying a current to the substrate heating units 1481 and 1482 based on a control signal input from the control unit 9 illustrated in FIG. 1, the heating unit drive unit causes the substrate heating units 1481 and 1482 to generate heat.

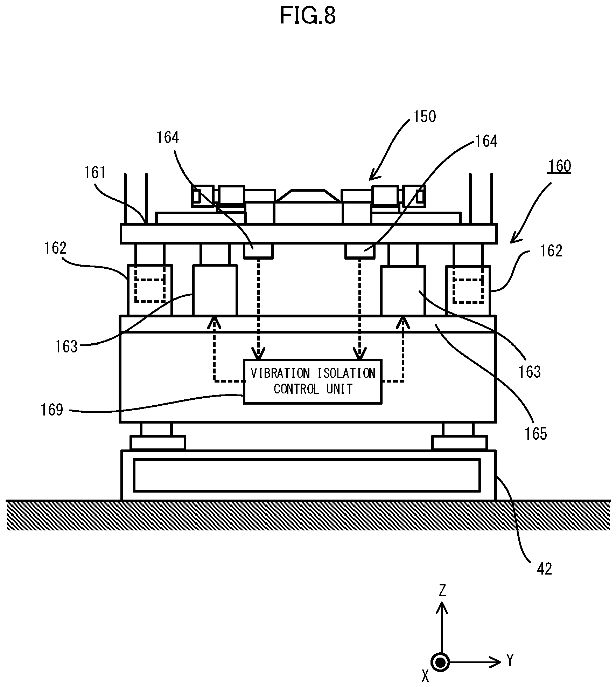

The vibration isolation unit 160 is what is called an active anti-vibration table, and collectively supports the chamber 120, the stage 141, the head 142, the stage drive unit 143, the head drive unit 144, the substrate heating units 1481 and 1482, and the position measurement unit 150. As illustrated in FIG. 8, the vibration isolation unit 160 includes a top plate 161, a base plate 165 arranged vertically downward the top plate 161, that is, on the -Z direction side, and a plate support portion 162 that has an anti-vibration mechanism, is fixed to the base plate 165, and supports the top plate 161 movably in the vertical direction and the horizontal direction on the +Z direction side. Here, the chamber 120, the stage 141, the head 142, the stage drive unit 143, the head drive unit 144, the substrate heating units 1481 and 1482, and the position measurement unit 150 are installed vertically upward side of the top plate 161, that is, on the +Z direction side. The plate support portion 162 has an anti-vibration mechanism using, for example, an air spring, a coil spring, or the like, and supports the top plate 161 movably along the vertical direction and the horizontal direction. The vibration isolation unit 160 further includes a vibration detection unit 164 that detects vibration transmitted to the top plate 161, a plate drive unit 163 that moves the top plate 161 relative to the plate support portion 162, and a vibration isolation control unit 169 that controls the plate drive unit 163 so as to reduce vibration transmitted to the top plate 161. The vibration detection unit 164 detects vibration in a three-dimensional direction, that is, the XYZ direction applied to the top plate 161. A plate drive unit 423 includes a hydraulic actuator, an electromagnetic actuator, a pneumatic actuator, a piezo actuator, a linear actuator, or the like, and applies a force acting in the Z axis direction or the horizontal direction with respect to the top plate 161. Based on the vibration detected by the vibration detection unit 164, the vibration isolation control unit 169 controls the plate drive unit 423 so that the top plate 161 moves so as to offset the vibration.

As illustrated in FIG. 2A, the bonder 1 includes the frame body 713 provided so as to surround the gate 1211 outside the chamber 120, and a gate drive unit 1212 that drives the gate 1211. The frame body 713 is a first frame body arranged facing the frame body 712, and when the seal member 711 of the conveying device 84 is brought into the first state, the seal member 711 is brought into close contact with the entire circumference of the frame body 713. When the substrates W1 and W2 are conveyed into the chamber 120 of the bonder 1, if the chamber 120 is opened to the atmosphere each time, it takes time to increase the degree of vacuum in the chamber 120 again after the substrates W1 and W2 are conveyed. Therefore, in the bonding system according to the present embodiment, it is required to convey the substrates W1 and W2 from the load lock unit 83 and the chamber 843 of the conveying device 84 to the chamber 120 of the bonder 1 while maintaining the inside of the chamber 120 of the bonder 1 at a high degree of vacuum. On the other hand, when the substrates W1 and W2 are bonded to each other in the bonder 1, it is necessary to reduce the influence of vibration by bringing the conveying device 84 and the bonder 1 into a disconnected state. Therefore, the bonding system according to the present embodiment is configured to include the frame bodies 712 and 713 and the seal member 711 as mentioned earlier.

Returning to FIG. 1, the control unit 9 is a control system including, for example, a personal computer, and includes a central processing unit (CPU) and a memory. The memory stores a program executed by the CPU. The control unit 9 converts, into measurement information, measurement signals input from the pressure sensor 148 and the position measurement unit 150, and acquires the measurement information. The control unit 9 converts, into photographed image information, photographed image signals input from the first imaging unit 151 and the second imaging unit 152, and acquires the photographed image information. Furthermore, by outputting a control signal to each of the holding portion drive unit, the piezo actuator 1411, a pressing drive unit that drives the pressing mechanism, the heating unit drive unit, the stage drive unit 403, and the head drive unit 404, the control unit 9 controls the operations of them. As illustrated in FIG. 7B, the control unit 9 calculates position gap amounts dxa and dya between the set of alignment marks MK1a and MK2a provided on the substrates W1 and W2 based on the photographed image GAa acquired from the first imaging unit 501. Note that FIG. 7B illustrates a state where one set of alignment marks MK1a and MK2a is shifted from each other. Similarly, the control unit 9 calculates position gap amounts dxb and dyb between another set of alignment marks MK1b and MK2b provided on the substrates W1 and W2 based on the photographed image GAb acquired from the second imaging unit 502. Thereafter, the control unit 9 calculates relative position gap amounts dx, dy, and dθ of the two substrates W1 and W2 in the X direction, the Y direction, and a rotation direction around the Z axis based on the position gap amounts dxa, dya, dxb, and dyb of these two sets of alignment marks and the geometric relationship of the two sets of marks. Then, the control unit 9 moves the head 402 in the X direction and the Y direction and rotates the head 402 about the Z axis so as to reduce the calculated position gap amounts dx, dy, and dθ. In this manner, the bonder 1 executes the alignment operation of correcting the position gap amounts dx, dy, and dθ in the horizontal direction of the two substrates W1 and W2. By outputting control signals to the activation treatment device 2, the conveying devices 82, 84, and 86, the cleaning device 3, the gate drive units 8332, 8322, 8532, 8522, 8622, 8422, and 1212, and the seal drive unit 714, the control unit 9 controls the operations of them.

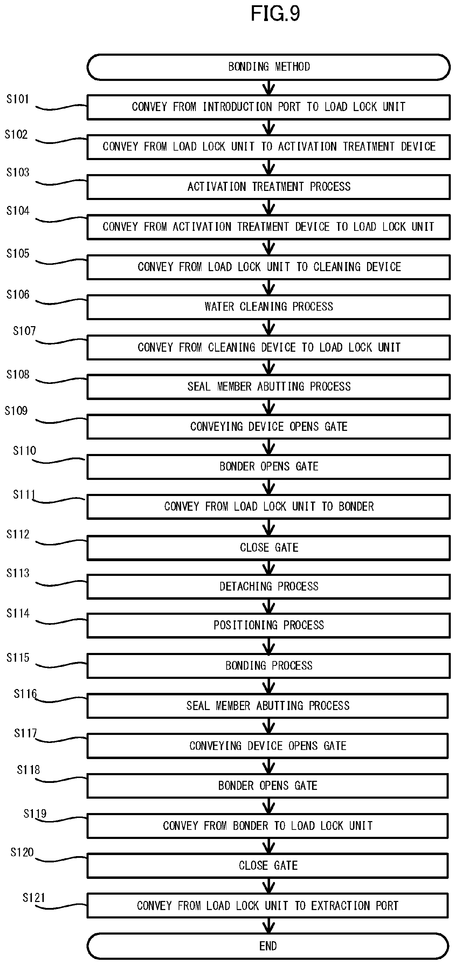

Next, regarding the bonding system according to the present embodiment, a flow of the operation from when the substrates W1 and W2 are put in the bonding system to when the substrates W1 and W2 are bonded and extracted from the bonding system will be described with reference to FIGS. 9 to 15. Here, it is assumed that the substrates W1 and W2 are arranged in the introduction ports 811 and 812 in advance. The substrates W1 and W2 include any of, for example, an Si substrate, a glass substrate, an oxide substrate (e.g., a silicon oxide (SiO₂) substrate, an alumina substrate (Al₂O₃), or the like), and a nitride substrate (e.g., silicon nitride (SiN) or aluminum nitride (AlN)). Note that at least one of the substrates W1 and W2 may have a metal part and an insulation film being exposed on the bonding surface thereof. Alternatively, at least one of the substrates W1 and W2 may be one in which an insulation film formed by depositing an oxide or a nitride on the bonding surface thereof is exposed. Here, a description is made assuming that the substrate W1 is a glass substrate or an oxide substrate, and the substrate W2 is an Si substrate or a nitride substrate. The substrate W2 held by the head 142 in the bonder 1, for example, is arranged in the introduction port 811, and the substrate W1 placed on the stage 141 in the bonder 1, for example, is arranged in the introduction port 812.

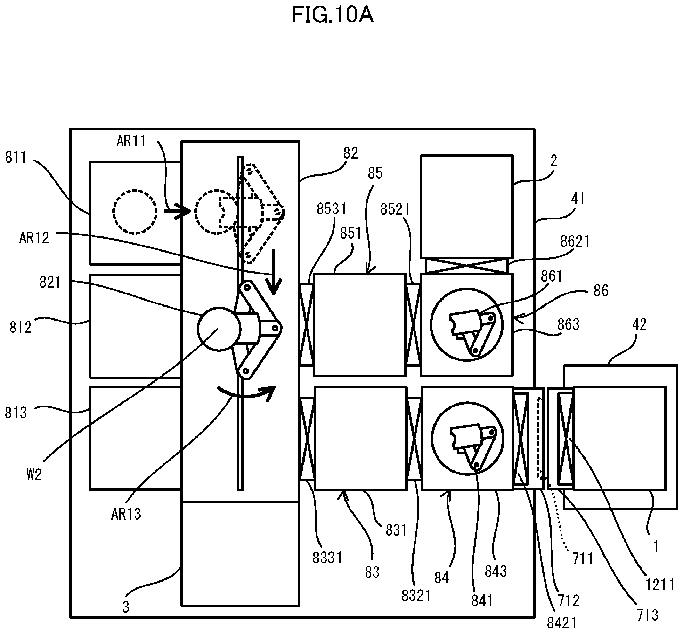

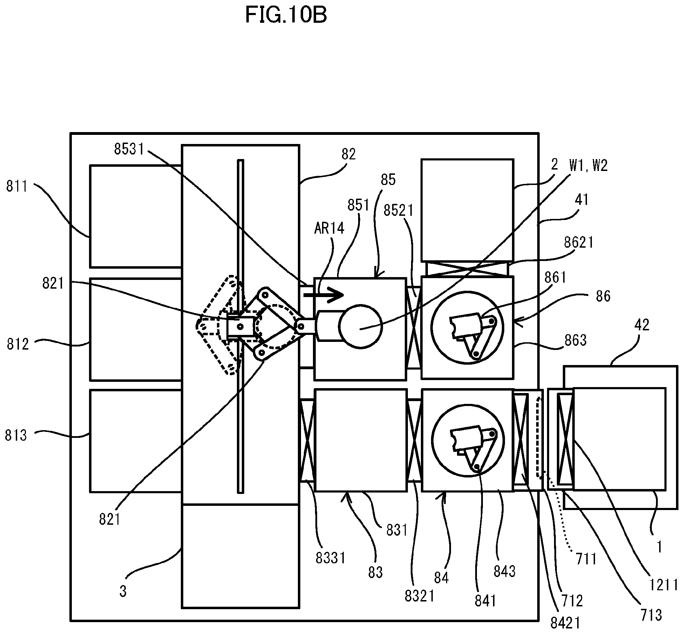

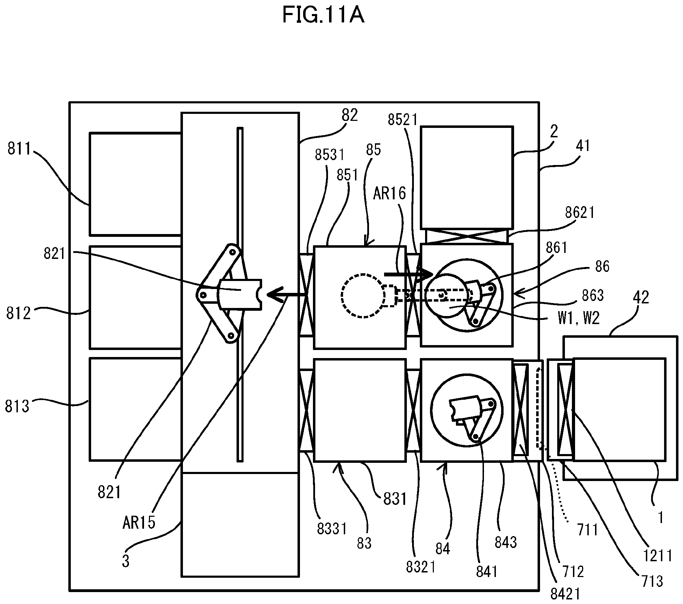

First, as shown in FIG. 9, the bonding system conveys the substrates W1 and W2 from the introduction ports 811 and 812 to the load lock unit 85 (step S101). Here, when the substrate W2 is arranged in the introduction port 811, the conveying robot 821 extracts the substrate W2 from the introduction port 811 as indicated by an arrow AR11 in FIG. 10A. Then, as indicated by an arrow AR12 in FIG. 10A, the conveying robot 821 moves to a position where the substrate W2 is carried into the load lock unit 85 in the conveying device 82 in a state of holding the substrate W2. When the substrate W1 is arranged in the introduction port 812, the conveying robot 821 extracts the substrate W1 from the introduction port 812, and then stands by in a state of holding the substrate W1. Next, the gate 8531 of the load lock unit 85 is opened, and the conveying robot 821 turns so that the tip end part of the arm faces the load lock unit 85 side as indicated by an arrow AR13 in FIG. 10A. Subsequently, as indicated by an arrow AR14 in FIG. 10B, by extending the arm, the conveying robot 821 inserts the tip end part of the arm into the chamber 851 of the load lock unit 85. Then, the substrates W1 and W2 are transferred from the tip end part of the arm to a stage provided in the chamber 851 of the load lock unit 85. Thereafter, upon completing the transfer of the substrates W1 and W2 to the stage in the chamber 851, the conveying robot 821 contracts the arm as indicated by an arrow AR15 in FIG. 11A. After closing the gate 8531, the load lock unit 85 decompresses the inside of the chamber 851.

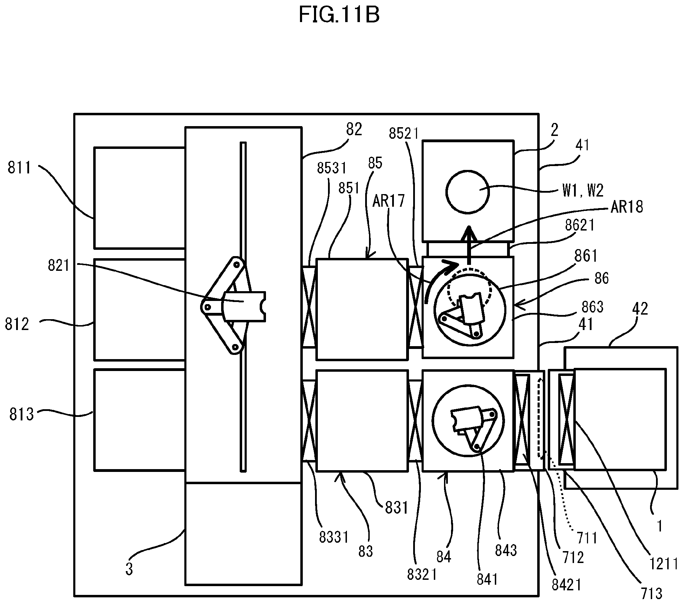

Next, as shown in FIG. 9, the bonding system conveys the substrates W1 and W2 from the load lock unit 85 to the activation treatment device 2 (step S102). Here, as illustrated in FIG. 11A, after the load lock unit 85 opens the gate 8521, the conveying robot 861 extends the arm in a state where the tip end part of the arm faces the load lock unit 85 side. Then, when the substrates W1 and W2 are transferred from the stage to the tip end part of the arm in the chamber 851 of the load lock unit 85, the conveying robot 861 contracts the arm to extract the substrates W1 and W2 from the chamber 851 as indicated by an arrow AR16. Thereafter, the load lock unit 85 closes the gate 8521. Next, the conveying robot 861 turns so that the tip end part of the arm faces the activation treatment device 2 side as indicated by an arrow AR17 in FIG. 11B. Then, the conveying device 86 opens the gate 8621. Subsequently, the conveying robot 861 extends the arm and inserts the tip end part of the arm into the activation treatment device 2. Then, as indicated by an arrow AR18, the substrates W1 and W2 are transferred from the tip end part of the arm of the conveying robot 861 to the stage 210 (see FIG. 4) of the activation treatment device 2. Thereafter, after the conveying robot 861 contracts the arm, the conveying device 86 closes the gate 8621.

Returning to FIG. 9, subsequently, the activation treatment device 2 performs an activation treatment process of activating the bonding surface by performing at least one of reactive ion etching using nitrogen gas and irradiation with nitrogen radicals with respect to at least one of the bonding surfaces to be bonded to each other of the substrates W1 and W2 (step S103). Here, the activation treatment device 2 has a different treatment sequence depending on the type of substrate to be subjected to the activation treatment on the bonding surface. When performing the activation treatment on the substrate W1, that is, the bonding surface of the glass substrate or the oxide substrate, the activation treatment device 2 first introduces N₂ gas into the treatment chamber 212 from the nitrogen gas storage unit 221A through the supply pipe 223A by opening the supply valve 222A illustrated in FIG. 2. Next, the activation treatment device 2 applies a high-frequency bias to the substrates W1 and W2 placed on the stage 210 by the bias application unit 217 in a state where the supply of the high-frequency current from the high-frequency power source 216 to the induction coil 215 is stopped. Due to this, reactive ion etching (RIE) using N₂ gas is performed with respect to the bonding surface of the substrate W1. Subsequently, the activation treatment device 2 starts supply of a high-frequency current from the high-frequency power source 216 to the induction coil 215, and generates plasma with N₂ gas. At this time, the activation treatment device 2 stops the application of the high-frequency bias to the substrate W1 by the bias application unit 217. In this manner, the bonding surface of the substrate W1 is irradiated with N₂ radicals.

On the other hand, when performing the activation treatment on the substrate W2, that is, the bonding surface of the Si or nitride substrate, the activation treatment device 2 first introduces O₂ gas into the treatment chamber 212 from the oxygen gas storage unit 221B through the supply pipe 223B by opening the supply valve 222B. Next, the activation treatment device 2 applies a high-frequency bias to the substrate W2 placed on the stage 210 by the bias application unit 217 in a state where the supply of the high-frequency current from the high-frequency power source 216 to the induction coil 215 is stopped. Due to this, reactive ion etching (RIE) using O₂ gas is performed with respect to the bonding surface of the substrate W2. Subsequently, the activation treatment device 2 exhausts the O₂ gas in the chamber 612 by closing the supply valve 622B to stop the supply of the O₂ gas from the O₂ gas storage unit 621B into the chamber 612. Thereafter, the activation treatment device 2 introduces Nz gas into the treatment chamber 212 from the nitrogen gas storage unit 221A through the supply pipe 223A by opening the supply valve 222A. Thereafter, the activation treatment device 2 starts supply of a high-frequency current from the high-frequency power source 216 to the induction coil 215, and generates plasma with N₂ gas. At this time, the activation treatment device 2 stops the application of the high-frequency bias to the substrate W2 by the bias application unit 217. In this manner, the bonding surface of the substrate W2 is irradiated with N₂ radicals.

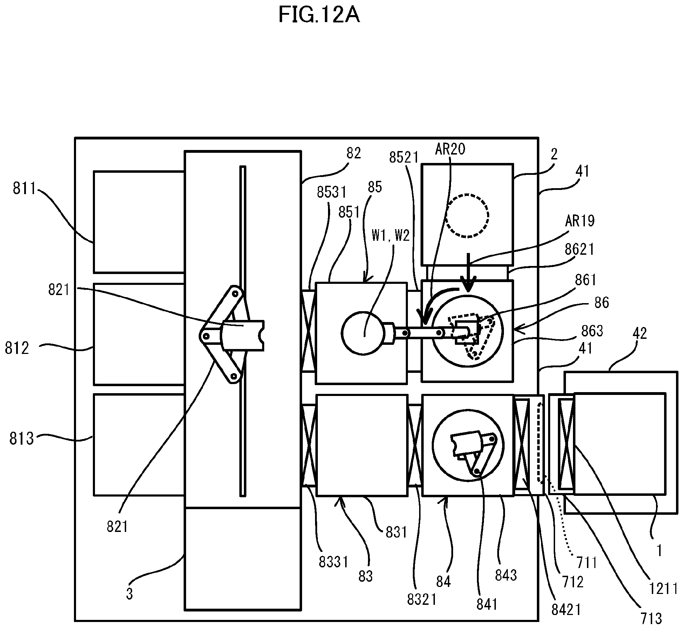

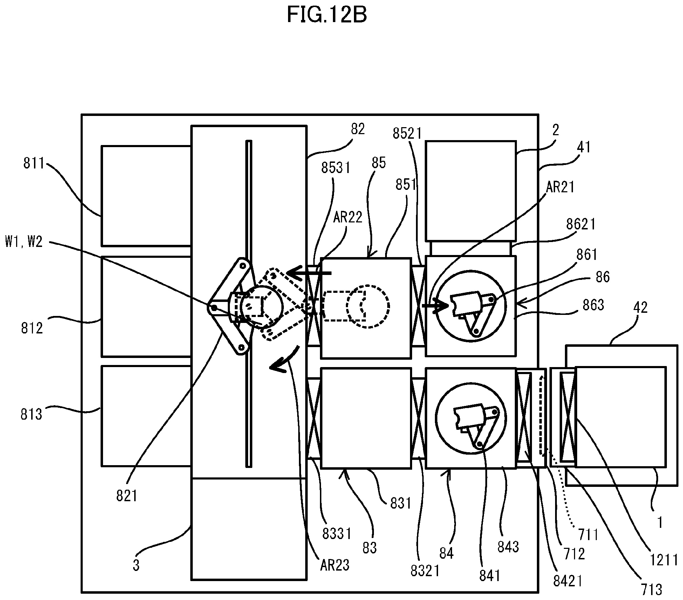

Returning to FIG. 9, thereafter, the conveying device 86 conveys the substrates W1 and W2 from the activation treatment device to the load lock unit 85 (step S104). Here, when the conveying device 86 opens the gate 8621, the conveying robot 861 extends the arm and inserts the tip end part of the arm into the activation treatment device 2. Then, in the activation treatment device 2, the substrates W1 and W2 are transferred from the stage 210 to the tip end part of the arm. Next, by contracting the arm, the conveying robot 861 extracts the substrates W1 and W2 from the activation treatment device 2 as indicated by an arrow AR19 in FIG. 12A. Subsequently, when the conveying robot 861 turns so that the tip end part of the arm faces the load lock unit 85 side as indicated by an arrow AR20, the gate 8521 of the load lock unit 85 is opened. Thereafter, the conveying robot 861 extends the arm and inserts the tip end part of the arm into the chamber 851 of the load lock unit 85. Then, the substrates W1 and W2 are transferred from the tip end part of the arm to the stage in the chamber 851. Next, as indicated by an arrow AR21 in FIG. 12B, the conveying robot 861 contracts the arm, and the load lock unit 85 closes the gate 8521.

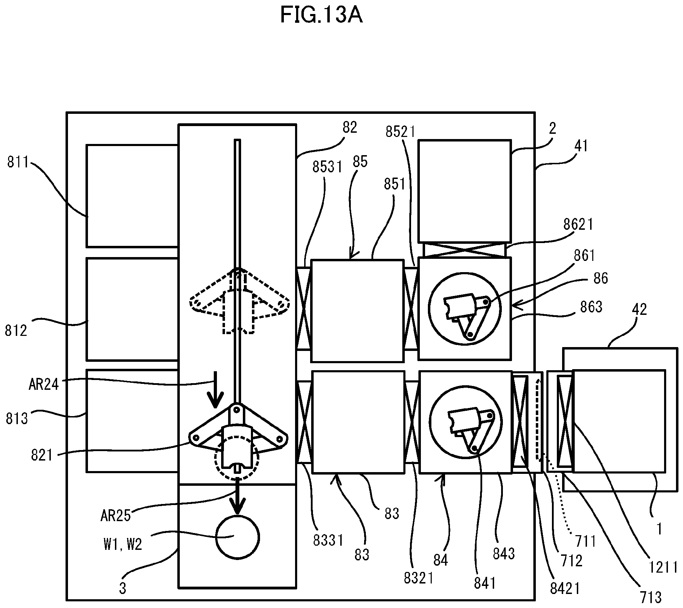

Next, the conveying device 82 conveys the substrates W1 and W2 from the load lock unit 85 to the cleaning device 3 (step S105). Here, after the load lock unit 85 opens the gate 8531, the conveying robot 821 extends the arm and inserts the tip end part of the arm into the chamber 851 of the load lock unit 85 in a state where the tip end part of the arm faces the load lock unit 85 side. Then, the substrates W1 and W2 are transferred from the stage in the chamber 851 to the tip end part of the arm of the conveying robot 821. Thereafter, as indicated by an arrow AR22 in FIG. 12B, after the conveying robot 821 extracts the substrates W1 and W2 from the load lock unit 85 by contracting the arm, the load lock unit 85 closes the gate 8531. Next, the conveying robot 821 turns so that the tip end part of the arm faces the cleaning device 3 side as indicated by an arrow AR23. Subsequently, as indicated by an arrow AR24 in FIG. 13A, the conveying robot 821 moves to a position where the substrates W1 and W2 in the conveying device 82 are carried into the cleaning device 3 in a state of holding the substrates W1 and W2. Thereafter, the conveying robot 821 extends the arm and inserts the tip end part of the arm into the cleaning device 3. Then, as indicated by an arrow AR25, the substrates W1 and W2 are transferred from the tip end part of the arm of the conveying robot 821 to a stage of the cleaning device 3.

Returning to FIG. 9, subsequently, the cleaning device 3 executes a water cleaning process of cleaning the bonding surfaces of the substrates W1 and W2 while spraying water onto the bonding surfaces (step S106). Here, the cleaning device 3 cleans the entire surfaces of the bonding surfaces of the substrates W1 and W2 by scanning, in the XY direction, the stage on which the substrates W1 and W2 are placed while spraying water to which ultrasonic waves are applied from a cleaning head onto the bonding surfaces of the substrates W1 and W2. This removes foreign matters adhering to the bonding surfaces of the substrates W1 and W2. Subsequently, after stopping the discharge of water by the cleaning head, the cleaning device 3 rotates the stage to spin dry the substrate, thereby completing cleaning treatment.

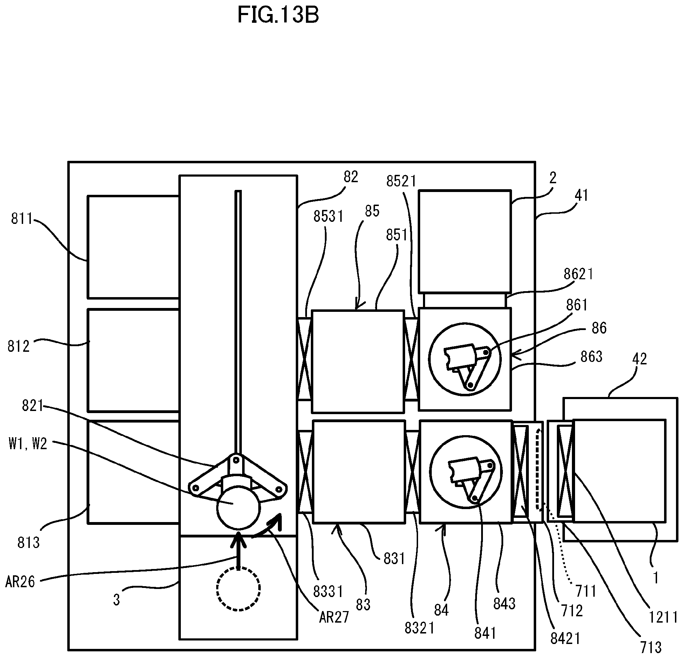

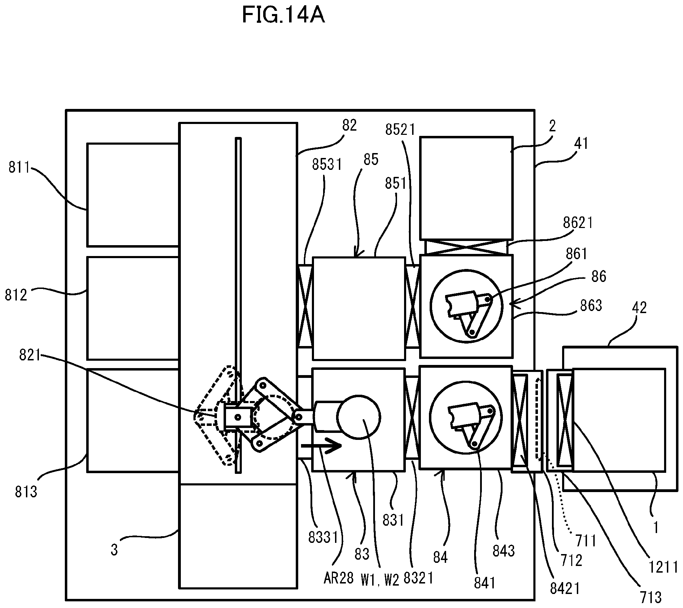

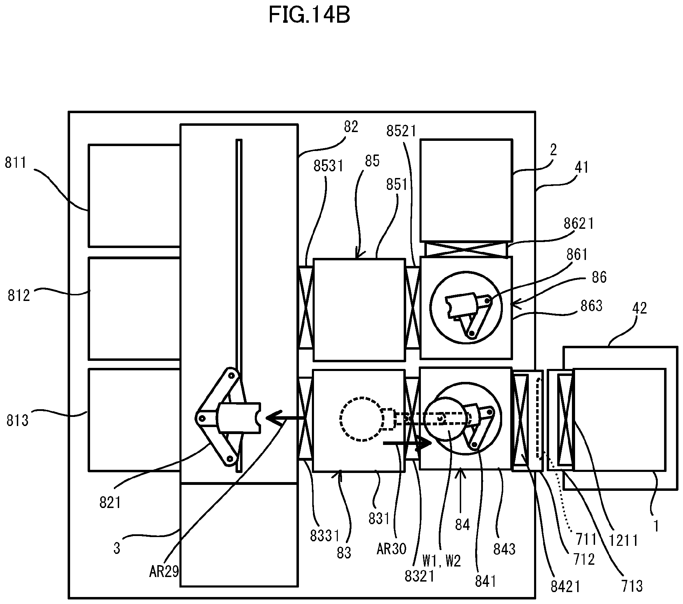

Thereafter, the conveying device 82 conveys the substrates W1 and W2 from the cleaning device 3 to the load lock unit 83 (step S107). Here, the conveying robot 821 extends the arm and inserts the tip end part of the arm into the cleaning device 3, and transfers the substrates W1 and W2 from the stage to the tip end part of the arm. Next, by contracting the arm, the conveying robot 821 extracts the substrates W1 and W2 from the cleaning device 3 as indicated by an arrow AR26 in FIG. 13B. Subsequently, the conveying robot 821 turns so that the tip end part of the arm faces the load lock unit 83 side in a state of holding the substrates W1 and W2 as indicated by an arrow AR27. Thereafter, when the load lock unit 83 opens the gate 8331, the conveying robot 821 inserts the tip end part of the arm into the chamber 831 of the load lock unit 83 by extending the arm as indicated by an arrow AR29 in FIG. 14A. Then, the substrates W1 and W2 are transferred from the tip end part of the arm to a stage in the chamber 831. Next, upon completing the transfer of the substrates W1 and W2 to the stage in the chamber 831, the conveying robot 821 contracts the arm as indicated by an arrow AR30 in FIG. 14B. Then, the load lock unit 83 closes the gate 8331.

Returning to FIG. 9, next, by filling the filling region S71 of the seal member 711 with gas, the seal drive unit 714 of the conveying device 84 executes seal member abutting process of bringing the seal member 711 from the second state shown in FIG. 2A to the first state shown in FIG. 2B (step S108). Returning to FIG. 9, subsequently, a second gate opening process in which the conveying device 84 opens the gate 8421, which is the second gate, is executed (step S109). Due to this, the air existing in the region S72 between the frame body 713 and the frame body 712 illustrated in FIG. 2B is discharged to the outside of the region S72 by the vacuum pump for exhausting the gas existing in the chamber 843 of the conveying device 84. Thereafter, as shown in FIG. 9, the bonder 1 executes a first gate opening process of opening the gate 1211, which is the first gate (step S110).

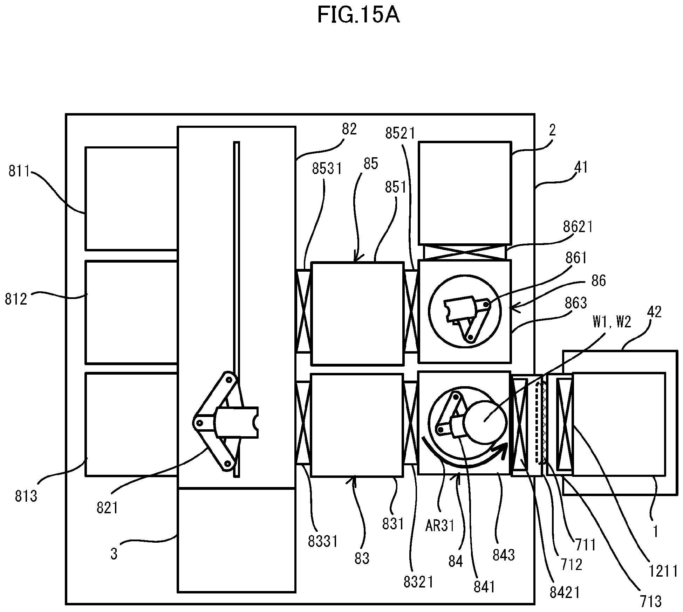

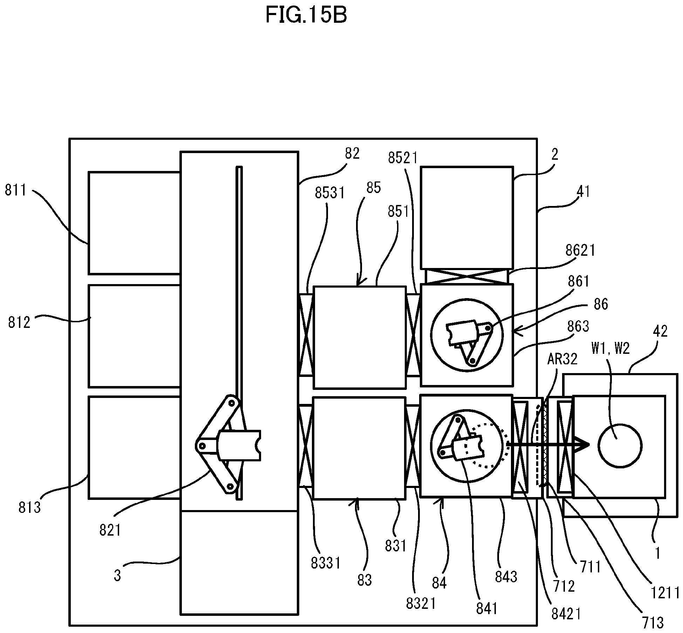

Next, the conveying device 84 executes a conveying process of conveying the substrates W1 and W2 from the load lock unit 83 to the bonder 1 (step S111). Here, after the load lock unit 83 opens the gate 8321, the conveying robot 841 extends the arm in a state where the tip end part of the arm faces the load lock unit 83 side, and inserts the tip end part of the arm into the chamber 831 of the load lock unit 83. Then, in the chamber 831 of the load lock unit 83, when the substrates W1 and W2 are transferred from the stage to the tip end part of the arm, the conveying robot 841 extracts the substrates W1 and W2 from the load lock unit 83 by contracting the arm as indicated by an arrow AR31 in FIG. 14B. Next, the load lock unit 83 closes the gate 8321. Subsequently, the conveying robot 841 turns so that the tip end part of the arm faces the bonder 1 side as indicated by an arrow AR31 in FIG. 15A. Here, when extracting the substrate W2 supported by the head 142 in the bonder 1 from the load lock unit 83, the conveying robot 841 turns and reverses the tip end part of the arm at the same time. Thereafter, the conveying robot 841 extends the arm and inserts the tip end part of the arm into the bonder 1. Then, as indicated by an arrow AR32 in FIG. 15B, the substrate W2 is transferred from the tip end part of the arm of the conveying robot 841 to the head 142 of the bonder 1, or the substrate W1 is transferred from the tip end part of the arm of the conveying robot 841 to the stage 141 of the bonder 1. Then, the conveying robot 841 contracts the arm.

Returning to FIG. 9, subsequently, the bonder 1 closes the gate 1211, and the conveying device 84 closes the gate 8421 (step S112). Thereafter, by contracting the seal member 711 by discharging the gas in the filling region S71 of the seal member 711, the seal drive unit 714 of the conveying device 84 executes detaching process of bringing the seal member into the second state of being separated from the frame body 713 of the bonder 1 (step S113).

Thereafter, after bringing the substrates W1 and W2 close to each other by a preset distance, the bonder 1 executes a positioning process of performing positioning (alignment) of the substrate W2 with respect to the substrate W1 based on the position gap amount measured by the position measurement unit 150 (step S114). Next, by bringing the head 142 close to the stage 141 again, the bonder 1 brings the two substrates W1 and W2 into contact with each other, and then applies pressure in a direction in which the two substrates W1 and W2 are in close contact with each other and heats the substrates W1 and W2, thereby bonding the two substrates W1 and W2 (step S115). At this time, the bonding surfaces of the substrates W1 and W2 are covered with an OH group or water molecules. Due to this, by bringing the bonding surfaces of the substrates W 1 and W2 into contact with each other, the substrates W 1 and W2 are temporarily bonded by hydrogen bonding between the OH groups or between the water molecules. Here, after abutting the central parts of the substrates W1 and W2 on each other in a state where the central parts of the substrates W1 and W2 are pressed and bent by the pressing mechanisms 1431 and 1432, the bonder 1 temporarily bonds the substrates W1 and W2 by bringing the bonding surfaces into contact with each other from the central parts of the substrates W1 and W2 toward the peripheral parts.

Subsequently, the seal drive unit 714 of the conveying device 84 executes the seal member abutting process of bringing the seal member 711 from the second state mentioned earlier to the first state mentioned earlier again (step S116). Thereafter, after the conveying device 84 executes the second gate opening process of opening the gate 8421 (step S117), the bonder 1 executes the first gate opening process of opening the gate 1211 (step S118). Next, the conveying device 84 conveys the substrates W1 and W2 bonded to each other from the bonder 1 to the load lock unit 84 (step S119). Here, the conveying robot 841 extends the arm and inserts the tip end part of the arm into the bonder 1. Then, the substrates W1 and W2 bonded to each other are transferred from the stage 141 or the head 142 of the bonder 1 to the tip end part of the arm of the conveying robot 841. Next, by contracting the arm, the conveying robot 841 extracts the substrates W1 and W2 bonded to each other from the bonder 1. Subsequently, the conveying robot 841 turns so that the tip end part of the arm faces the load lock unit 83 side. Thereafter, by extending the arm in a state where the tip end part of the arm faces the load lock unit 83 side, the conveying robot 841 inserts the tip end part of the arm into the chamber 831 of the load lock unit 83. Then, in the chamber 831, when the substrates W1 and W2 bonded to each other are transferred from the tip end part of the arm to the stage, the conveying robot 841 contracts the arm.

Thereafter, the bonder 1 closes the gate 1211, and the conveying device 84 closes the gate 8421 (step S120). At this time, by appropriately contracting the seal member 711, the seal drive unit 714 of the conveying device 84 executes the detaching process of bringing the seal member into the second state of being separated from the frame body 713 of the bonder 1.

Next, the conveying device 82 conveys the substrates W1 and W2 bonded to each other from the load lock unit 83 to the extraction port 813 (step S121). Here, when the load lock unit 83 opens the chamber 831 to the atmosphere and then opens the gate 8331, the conveying robot 821 extends the arm in a state where the tip end part of the arm faces the load lock unit 83 side, and inserts the tip end part of the arm into the chamber 831. Then, the substrates W1 and W2 bonded to each other are transferred from the stage in the chamber 831 to the tip end part of the arm of the conveying robot 821. Thereafter, after the conveying robot 821 extracts, from the load lock unit 83, the substrates W1 and W2 bonded to each other by contracting the arms, the load lock unit 83 closes the gate 8331. Subsequently, the conveying robot 821 turns so that the tip end part of the arm faces the opposite side to the load lock unit 83 side. Thereafter, in a state of holding the substrates W1 and W2 bonded to each other, the conveying robot 821 extends the arm, inserts the tip end part of the arm into the extraction port 813, and arranges, in the extraction port 813, the substrates W1 and W2 bonded to each other.

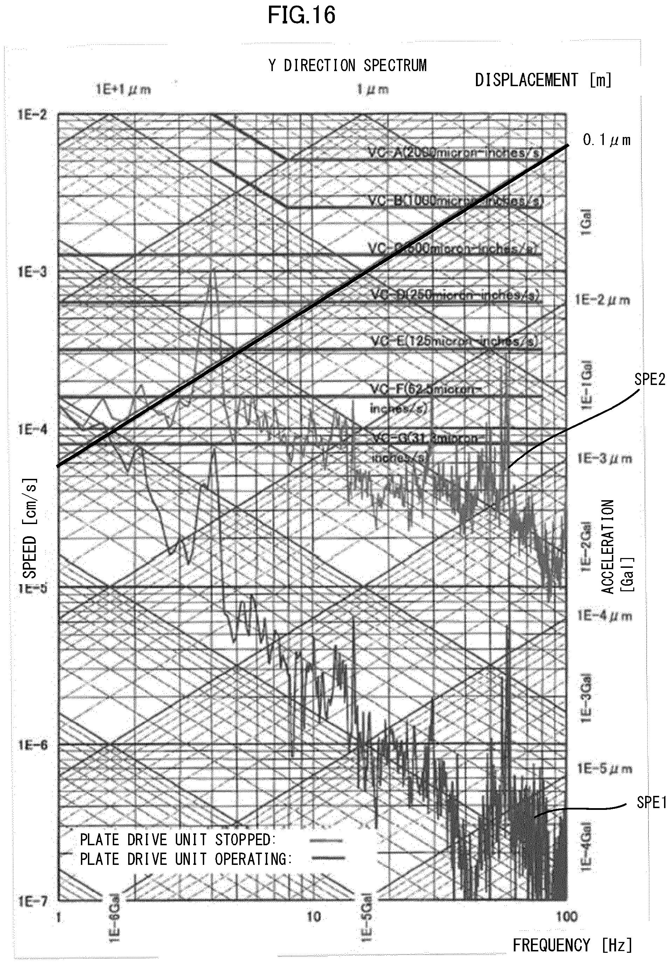

Here, the influence of the vibration isolation unit 160 on the position gap amounts of the substrates W1 and W2 bonded to each other in the bonder 1 will be described. In FIG. 16, a frequency spectrum SPE1 shows the frequency dependence of vibration amplitudes of the stage 141 and the head 142 when the plate drive unit 163 is operated by the vibration isolation unit 160, and a frequency spectrum SPE2 shows the frequency dependence of vibration amplitudes of the stage 141 and the head 142 when the plate drive unit 163 of the vibration isolation unit 160 is stopped. The broken line indicates a vibration amplitude of 0.1 µm. As illustrated in FIG. 16, the frequency spectrum SPE2 had an amplitude exceeding 0.1 µm in near 6 Hz. On the other hand, in the frequency spectrum SPE1, the amplitude near 6 Hz is reduced to less than 0 and 1 µm.

The position gap amounts of a plurality of sets of the substrates W1 and W2 bonded in a state where the plate drive unit 163 of the vibration isolation unit 160 is stopped were compared with the position gap amounts of the substrates W1 and W2 for the plurality of sets of substrates W1 and W2 bonded in a state where the plate drive unit 163 of the vibration isolation unit 160 is operating. As a result, it has been found that the position gap amount when the plate drive unit 163 of the vibration isolation unit 160 is stopped is about 100 nm, whereas the position gap amount when the plate drive unit 163 of the vibration isolation unit 160 is operating is reduced to about 40 nm. This is considered to reflect that the amplitude of a vibration component of the stage 141 and the head 142, particularly at a frequency near 6 Hz, is reduced to less than 0.1 µm by the vibration isolation unit 160, and therefore the position gap amount of the substrates W1 and W2 bonded to each other is reduced to equal to or less than 0.1 µm. As a result, the substrates W1 and W2 were successfully bonded to each other with position accuracy of the position gap amount of equal to or less than 0.1 µm.

As described above, in the bonding system according to the present embodiment, the conveying device 84 is installed on the second frame 41 that is different from the first frame 42 on which the bonder 1 is installed, the second frame 41 being arranged apart from the first frame 42. Then, after executing the positioning process of performing positioning of the substrate W2 with respect to the substrate W1 under reduced pressure in a state where the conveying device 84 is separated from the bonder 1, the bonder 1 executes the contact process of bringing the substrates W 1 and W2 into contact with each other under reduced pressure. Due to this, when the bonder 1 executes the positioning process and the contact process, the influence of an error in the position gap amount due to the vibration generated in the conveying device 84 is reduced, and therefore the substrates W1 and W2 can be bonded to each other with high position accuracy accordingly.

The bonder 1 according to the present embodiment includes the frame body 713 provided so as to surround the gate 1211 outside the chamber 120. On the other hand, the conveying device 84 includes the frame body 712 provided so as to surround the gate 8421 outside the chamber 843, facing the frame body 713, and arranged in a state of being separated from the frame body 713, and the seal member 711. Here, the seal member 711 is arranged over the entire circumference of the frame body 712 on the side facing the frame body 713 in the frame body 712, expands when gas is filled in the filling region S71, comes into close contact with the frame body 713, is brought into the first state mentioned earlier, contracts when the gas in the filling region S71 is discharged, and is brought into the second state of being separated from the frame body 713. This enables the conveying device 84 to convey the substrates W1 and W2 from the load lock unit 83 to the bonder 1 under reduced pressure.

Furthermore, before conveying the substrates W1 and W2 into the chamber 120 of the bonder 1, the control unit 9 according to the present embodiment controls the seal drive unit 714 to bring the seal member 711 into the first state mentioned earlier, then controls the gate drive unit 8422 to bring the gate 8421 into the open state, and then controls the gate drive unit 1212 to bring the gate 1211 into the open state. This can suppress the air existing between the gates 8421 and 1211 from flowing into the chamber 120 immediately after the seal portion 711 is brought into the first state. Therefore, it is possible to increase the degree of vacuum and the degree of cleanliness in the chamber 120. For example, in a case where the chamber 120 is ultra-high vacuum, when air existing between the gates 8421 and 1211 flows into the chamber 120, the degree of vacuum in the chamber 120 cannot be maintained at what is called ultra-high vacuum. On the other hand, in the bonding system according to the present embodiment, air existing between the gates 8421 and 1211 is caused to flow out to the chamber 843 side of the conveying device 84, the degree of vacuum in the chamber 120 can be maintained at what is called ultra-high vacuum.

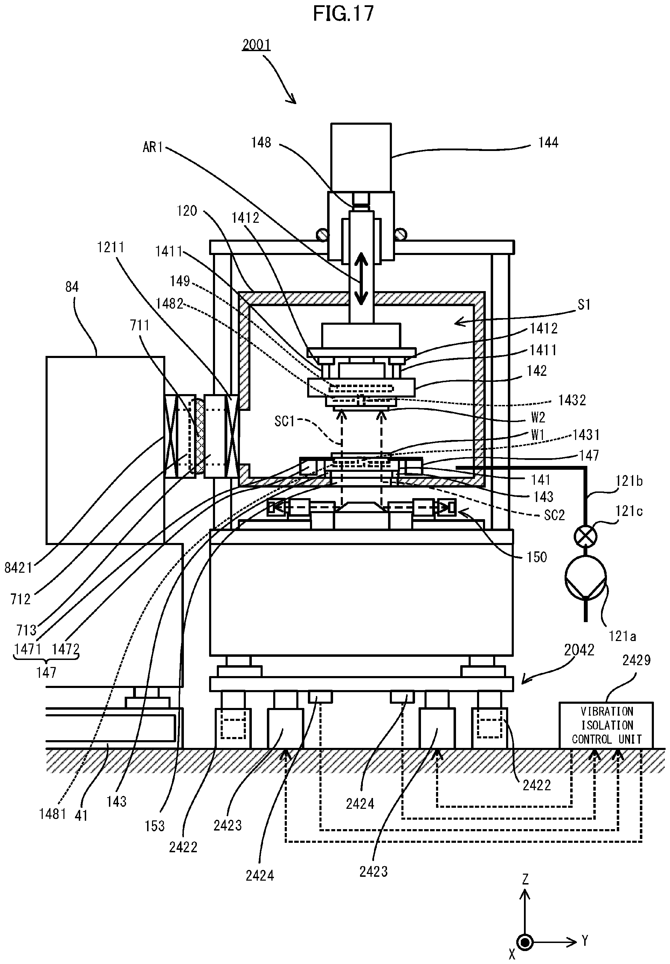

While the embodiment of the present invention has been described, the present invention is not limited to the configuration of the above-described embodiment. For example, as illustrated in FIG. 17, a first frame 2042 on which a bonder 2001 is placed may be what is called an active anti-vibration table. Note that in FIG. 16, similar components to those in the embodiment are denoted by identical reference signs to those in FIG. 5. Here, the bonder 2001 is different from the bonder 1 according to the embodiment in not including a vibration isolation unit. The first frame 2042 includes a top plate 2421 on which the bonder 2001 is installed vertically upward, that is, on the +Z direction side, and a plate support portion 2422 having an anti-vibration mechanism, installed on the ground, and movably supporting the top plate 2421 on the +Z direction side. The plate support portion 2422 has an anti-vibration mechanism using, for example, an air spring, a coil spring, or the like, and supports the top plate 2421 movably along the Z axis direction. The first frame 2042 further includes a vibration detection unit 2424 that detects vibration transmitted to the top plate 421, a plate drive unit 2423 that moves the top plate 2421 relative to the plate support portion 2422, and a vibration isolation control unit 2429 that controls the plate drive unit 2423 so as to reduce vibration transmitted to the top plate 2421. The plate drive unit 2423 and the vibration isolation control unit 2429 have similar configurations to those of the plate drive unit 163 and the vibration isolation control unit 169 described in the first embodiment.

According to the present configuration, since the bonder 2001 can be configured not to include a vibration isolation unit, the configuration of the bonder 2001 can be simplified and reduced in weight accordingly.

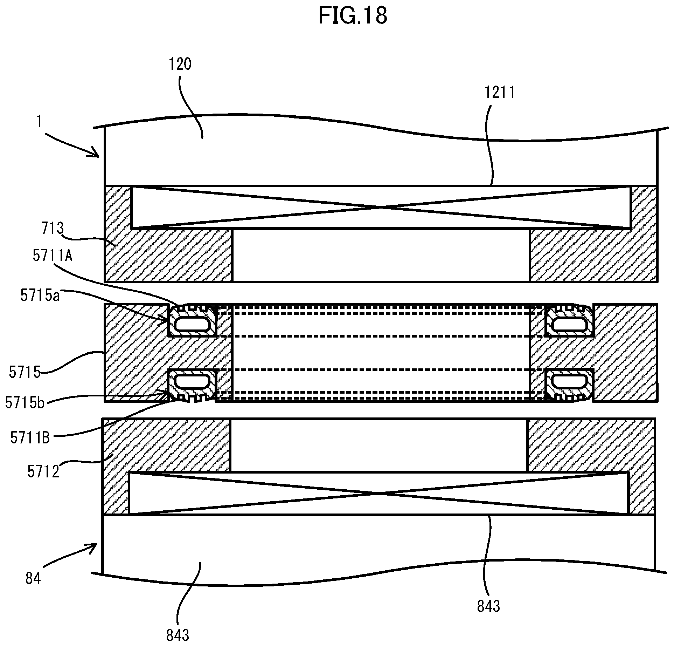

In the embodiment, an example in which the conveying device 84 includes the seal member 711 that is annular and is arranged over the entire circumference of the frame body 712 on a side of the frame body 712 facing the frame body 713 of the bonder 1 has been described. However, the present invention is not limited to this, and for example, the bonder 1 may include a seal member (not illustrated) that is annular and is arranged over the entire circumference of the frame body 713 on a side of the frame body 713 facing the frame body 712 of the conveying device 84. Alternatively, as illustrated in FIG. 18, the conveying device 84 may include a frame body 5712 not provided with a seal member, and a frame body 5715 provided with seal members 5711A and 5711B may be arranged between the frame body 713 of the bonder 1 and the frame body 5712. In the frame body 5715, annular grooves 5715a and 5715b are formed on surface sides facing the frame bodies 5712 and 713, respectively, and annular seal members 5711A and 5711B are fitted into the grooves 5715a and 5715b, respectively. Alternatively, inside regions of the seal members 5711A and 5711B may communicate with each other to form one annular seal member.

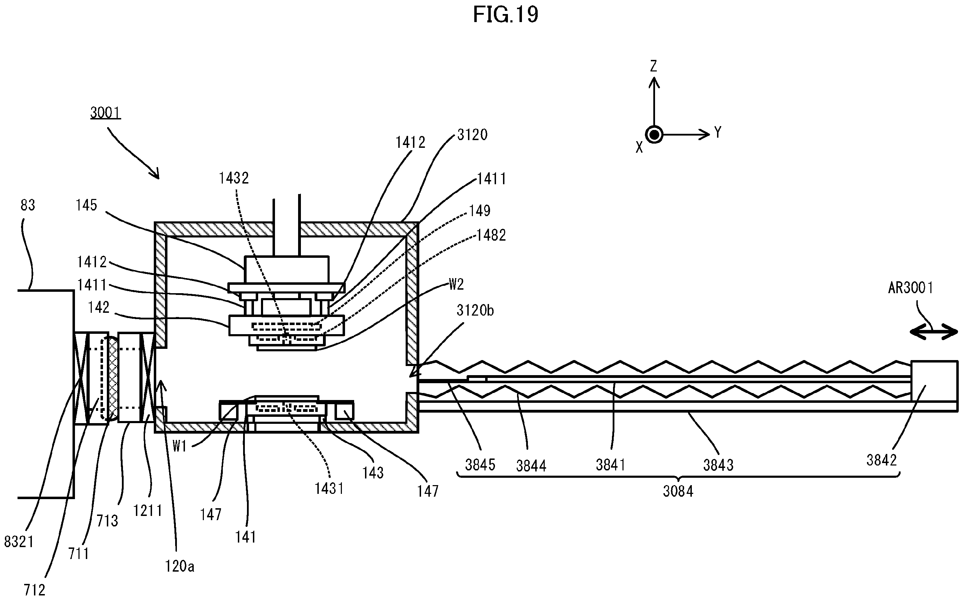

In the embodiment, an example in which the conveying device 84 includes the conveying robot 841 has been described, but the present invention is not limited to this. For example, as illustrated in FIG. 19, a conveying device 3084 may include a support rod 3841 that is long, is inserted into an opening 3120b provided in a chamber 3120 of a bonder 3001, and has one end part provided with a holding portion 3845 that holds the substrates W1 and W2, a support body 3842 supporting the support rod 3841 at the other end part of the support rod 3841, and a support body drive unit 3843 that drives the support body 3842. Note that in FIG. 19, similar components to those in the embodiment are denoted by identical reference signs to those in FIG. 5. Here, the bonder 3001 has a similar configuration to that of the bonder 1 described in the embodiment except for the chamber 3120. The conveying device 3084 has a bellows 3844 interposed between the outer peripheral part of the opening 3120b of the chamber 3120 and the support body 3842 in order to maintain the degree of vacuum in the chamber 3120. The support body drive unit 3843 includes, for example, a rail (not illustrated) that slidably supports a slider (not illustrated) to which the support body 3842 is fixed in the X axis direction, and a ball screw mechanism (not illustrated) that drives the slider in the X axis direction. As indicated by an arrow AR3003, the support body drive unit 3843 drives the support body 3842 in a direction in which the support rod 3841 is inserted into and removed from the chamber 3120, thereby conveying the substrates W1 and W2 from one of the load lock unit 83 and the bonder 3001 to the other. When this conveying device 3084 is adopted, the chamber 3120 of the bonder 1 may be configured to be connected to the gate 8321 of the load lock unit 83 via the frame bodies 712 and 713 and the seal member 711.

According to the present configuration, since the conveying means employs the bellows 3844, the inside of the chamber 3120 can be maintained in what is called a ultra-high vacuum state.

In the embodiment, the configuration may be adopted in which activation treatment where only one of the two substrates W1 and W2 is subjected to N₂RIE treatment and N₂ radical treatment, and the other is not subjected to at least one of the N₂RIE treatment and the N₂ radical treatment is performed.

In the embodiment, an example in which the bonder 1 applies pressure to the substrates W1 and W2 and performs heat treatment in a state where the entire bonding surfaces of the substrates W1 and W2 are in contact with each other has been described. However, the present invention is not limited to this, and for example, the bonder 1 may be configured only to apply pressure to the substrates W1 and W2 and not to perform the heat treatment in a state where the entire bonding surfaces of the substrates W1 and W2 are in contact with each other. Alternatively, the bonder 1 may be configured to execute only the heat treatment of the substrates W1 and W2 and not to apply pressure in a state where the entire bonding surfaces of the substrates W1 and W2 are in contact with each other. Pressurization and heat treatment may be performed to the substrates W1 and W2 in a device different from the bonder 1. For example, the bonder 1 may execute temporary bonding of the substrates W 1 and W2, and then another heating device (not illustrated) may perform heat treatment.

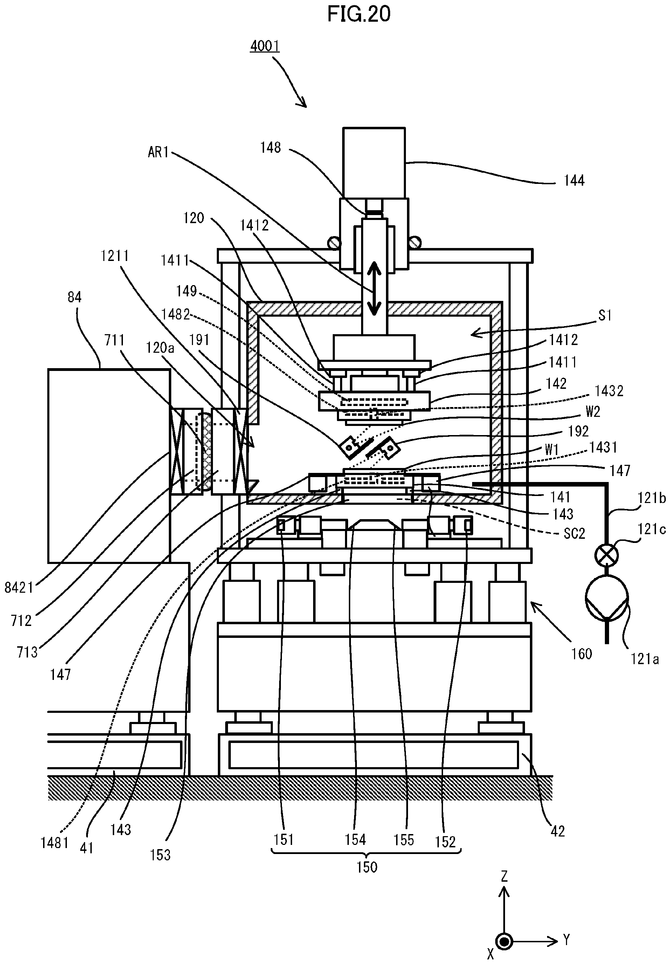

In the embodiment, an example in which in the activation treatment device 2 performs the activation treatment of activating the bonding surfaces of the substrates W1 and W2 has been described, but the present invention is not limited to this, and for example, as in a bonder 4001 illustrated in FIG. 20, inside of the chamber 120 may include particle beam sources 191 and 192 that irradiate the bonding surfaces of the substrates W1 and W2 with particle beams. Note that in FIG. 20, similar components to those in the embodiment are denoted by identical reference signs to those in FIG. 5. As the particle beam sources 191 and 192, for example, a fast atom beam (FAB) source, an ion gun, or the like can be adopted. The bonding system according to the present modification can be configured not to include the load lock unit 85, the conveying device 86, and the activation treatment device 2 in the bonding system according to the embodiment. In the bonding system according to the present modification, the conveying device 3084 illustrated in FIG. 19 may be adopted instead of the conveying device 84 in the bonding system according to the embodiment.

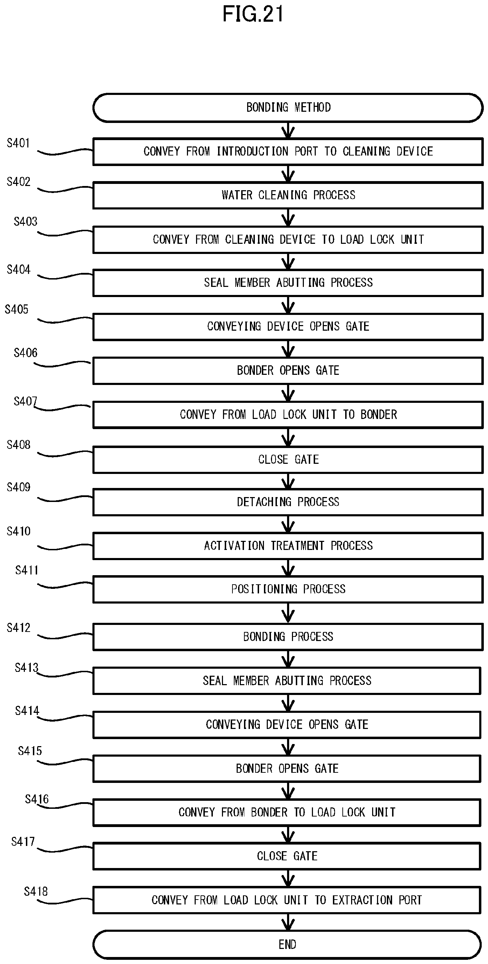

Here, regarding the bonding system according to the present modification, a flow of the operation from when the substrates W1 and W2 are put in the bonding system to when the substrates W1 and W2 are bonded and extracted from the bonding system will be described with reference to FIG. 21. First, the bonding system conveys the substrates W1 and W2 from the introduction ports 811 and 812 to the cleaning device 3 (step S401). Here, the substrates W1 and W2 are objects to be bonded including, for example, any of an Si substrate, an alumina substrate (Al₂O₃) including a sapphire substrate, gallium oxide (Ga₂O₃), a nitride substrate (e.g., silicon nitride (SiN), aluminum nitride (AlN), or gallium nitride (GaN)), a GaAs substrate, a silicon carbide (SiC) substrate, a lithium tantalate (Lt:LiTaO₃) substrate, a lithium niobate substrate (Ln:LiNbO₃), and diamond substrate. Alternatively, the substrates W1 and W2 may be substrates provided with an electrode formed of a metal such as Au, Cu, Al, or Ti on the bonding surface.

Next, the cleaning device 3 executes the water cleaning process of cleaning the bonding surfaces of the substrates W1 and W2 while spraying water onto the bonding surfaces (step S402). The treatment content in the water cleaning process is similar to the treatment in step S106 described in the embodiment. Subsequently, the conveying device 82 conveys the substrates W1 and W2 from the cleaning device 3 to the load lock unit 83 (step S403). Here, the load lock unit 83 may include a substrate heating unit (not illustrated) for heating the conveyed substrates W1 and W2, and remove moisture adhering to the bonding surfaces of the substrates W1 and W2 by heating the conveyed substrates W1 and W2. Thereafter, by filling the filling region S71 of the seal member 711 with gas, the seal drive unit 714 of the conveying device 84 the executes seal member abutting process of bringing the seal member 711 from the second state illustrated in FIG. 2A described in the embodiment to the first state illustrated in FIG. 2B (step S404). Returning to FIG. 20, next, the second gate opening process in which the conveying device 84 opens the gate 8421 is executed (step S405). Subsequently, the bonder 4001 executes the first gate opening process of opening the gate 1211 (step S406).

Next, the conveying device 84 executes the conveying process of conveying the substrates W1 and W2 from the load lock unit 83 to the bonder 4001 (step S407). Subsequently, the bonder 4001 closes the gate 1211, and the conveying device 84 closes the gate 8421 (step S408). Thereafter, by contracting the seal member 711 by discharging the gas in the filling region S71 of the seal member 711, the seal drive unit 714 of the conveying device 84 executes detaching process of bringing the seal member into the second state of being separated from the frame body 713 of the bonder 4001 (step S409).

Next, the bonder 4001 performs an activation treatment process of activating the bonding surface of each of the two substrates W1 and W2 in a state where the inside of the chamber 120 is in a decompressed atmosphere (step S410). Here, by irradiating the bonding surfaces of the substrates W1 and W2 with the particle beam emitted from the particle beam sources 191 and 192, the bonder 4001 performs the activation treatment on the bonding surfaces of the substrates W1 and W2. Subsequently, after bringing the substrates W1 and W2 close to each other by a preset distance, the bonder 4001 executes the positioning process of performing positioning (alignment) of the substrate W2 with respect to the substrate W1 based on the position gap amount measured by the position measurement unit 150 (step S411). Thereafter, by bringing the head 142 close to the stage 141 again, the bonder 4001 brings the two substrates W1 and W2 into contact with each other, and then applies pressure in a direction in which the two substrates W1 and W2 are in close contact with each other, thereby bonding the two substrates W 1 and W2 (step S412). In the case of the present modification, a dangling bond formed by activation treatment exists on the bonding surfaces of the substrates W1 and W2. Due to this, by bringing the bonding surfaces of the substrates W1 and W2 into contact with each other, the substrates W1 and W2 are bonded to each other via the dangling bond. For example, when a metal region is exposed on the bonding surfaces of the substrates W1 and W2, heat treatment of the substrates W1 and W2 may be used in combination.

Next, the seal drive unit 714 of the conveying device 84 executes the seal member abutting process of bringing the seal member 711 from the second state mentioned earlier to the first state mentioned earlier again (step S413). Subsequently, after the conveying device 84 executes the second gate opening process of opening the gate 8421 (step S414), the bonder 4001 executes the first gate opening process of opening the gate 1211 (step S415). Thereafter, the conveying device 84 conveys the substrates W1 and W2 bonded to each other from the bonder 1 to the load lock unit 84 (step S416). Next, the bonder 4001 closes the gate 1211, and the conveying device 84 closes the gate 8421 (step S417). Next, the conveying device 82 conveys the substrates W1 and W2 bonded to each other from the load lock unit 83 to the extraction port 813 (step S418).

According to the present configuration, it is possible to perform bonding after performing the activation treatment process while maintaining the inside of the chamber 120 in what is called a ultra-high vacuum state, it is possible to apply the present invention to direct bonding of the substrates W1 and W2 in ultra-high vacuum.

In the embodiment, an example in which the vibration isolation unit 160 of the bonder 1 is what is called an active anti-vibration table has been described, but the present invention is not limited to this, and for example, the vibration isolation unit 160 may be what is called a passive anti-vibration table in which the top plate 161 is supported by a support portion simply having an anti-vibration mechanism such as an air spring or a magnetic spring.

In the embodiment, an example in which the substrates W1 and W2 are bonded to each other has been described, but the present invention is not limited to this, and for example, a configuration may be adopted in which a substrate and a chip are bonded to each other.

The present invention enables various embodiments and modifications without departing from the broad spirit and scope of the present invention. The above-described embodiment is for describing the present invention, and do not limit the scope of the present invention. That is, the scope of the present invention is indicated not by the embodiment but by the claims. Various modifications made within the scope of the claims and the meaning of the invention equivalent thereto are regarded as being within the scope of the present invention.

The present application is based on Japanese Patent Application No. 2021-059944 filed on March 31, 2021. The entire description, claims, and drawings of Japanese Patent Application No. 2021-059944 are incorporated herein by reference.

### Industrial Applicability

The present invention is suitable for manufacturing of, for example, a complementary MOS (CMOS) image sensor, a memory, an arithmetic element, and a micro electro mechanical system (MEMS).

### Reference Signs List

1, 2001, 3001, 4001 bonder
2 activation treatment device
3 cleaning device
9 control unit
41 second frame
42, 3042 first frame
82, 84, 86, 3084 conveying device
83, 85 load lock unit
120,831,843,851,863,3120 chamber
120a, 3120b opening
121a, 201a vacuum pump
121b, 201b exhaust pipe
121c, 201c exhaust valve
141 stage
142 head
143 stage drive unit
144 head drive unit
147 support mechanism
148 pressure sensor
150 position measurement unit
151 first imaging unit
152 second imaging unit
153 window portion
154, 155 mirror
161, 2421 top plate
162, 2422 plate support portion
163, 2423 plate drive unit
164, 2424 vibration detection unit
169, 2429 vibration isolation control unit
191, 192 particle beam source
212 treatment chamber
213 plasma chamber
215 induction coil
216, 217 high-frequency power source
220A nitrogen gas supply unit
220B oxygen gas supply unit
221A nitrogen gas storage unit
221B oxygen gas storage unit
222A, 222B supply valve
223A, 223B supply pipe
711, 5711A, 5711B seal member
712, 713, 5712, 5715 frame body
712a, 5715a, 5715b groove
714 seal drive unit
811, 812 introduction port
813 extraction port
821, 841, 861 conveying robot
1211, 8321, 8331, 8421, 8521, 8531, 8621 gate
1212, 8322, 8332, 8422, 8522, 8532, 8622 gate drive unit
1431, 1432 pressing mechanism
1471 support member
1472 support member drive unit
1481, 1481 substrate heating unit
3841 support rod
3842 support body
3843 support body drive unit
3844 bellows
3845 holding portion
CPR7 compressor
CV7 check valve
L70 intake/discharge pipe
L71 introduction pipe
L72 discharge pipe
M71, M72 pressure gauge
T7 tank
V71, V72 solenoid valve
W1, W2 substrate

## Claims

1. A bonding system that bonds two objects to be bonded, the bonding system comprising:
a bonder that executes a positioning process of performing positioning of the two objects to be bonded under reduced pressure, and then executes a contact process of bringing the two objects to be bonded into contact under reduced pressure; and
a conveying device that conveys, to the bonder, the two objects to be bonded,
wherein the bonder executes the positioning process and the contact process in a state where the conveying device is separated from the bonder.

2. The bonding system according to claim 1, wherein
the bonder includes
a first chamber maintained in a depressurized state,
a first gate provided in a part of the first chamber,
a first gate drive unit that drives opening and closing of the first gate, and
a first frame body provided to surround the first gate outside the first chamber, and
the conveying device includes
a second chamber maintained in a depressurized state,
a second gate provided in a part of the second chamber,
a second gate drive unit that drives opening and closing of the second gate,
a second frame body provided to surround the second gate outside the second chamber, facing the first frame body, and arranged in a state of being separated from the first frame body,
a seal member having an annular shape, formed with a filling region filled with a fluid inside the seal member, arranged between the first frame body and the second frame body, the seal member being brought into a first state where the seal member expands by filling of a fluid in the filling region, is brought into close contact with the first frame body, and seals a region between the first frame body and the second frame body, and a second state where the seal member contracts by discharge of a fluid in the filling region, and is brought into a state of being separated from at least one of the first frame body and the second frame body,
a seal drive unit that fills the filling region with a fluid and discharges a fluid filled in the filling region such that the seal member is brought into one of the first state and the second state, and
a conveying means that conveys at least one of the two objects to be bonded from an inside of the second chamber into an inside of the first chamber when the seal member is in the first state and the first gate and the second gate are in an open state.

3. The bonding system according to claim 2, further comprising a control unit that controls the first gate drive unit, the second gate drive unit, the seal drive unit, and the conveying means,
wherein before controlling the conveying means to convey at least one of the two objects to be bonded from the inside of the second chamber into the inside of the first chamber, the control unit controls the seal drive unit to bring the seal member from the second state into the first state, then controls the second gate drive unit to bring the second gate into an open state, and then controls the first gate drive unit to bring the first gate into an open state.

4. The bonding system according to claim 2 or 3, wherein
the bonder further includes
a first holding portion that holds any one of the two objects to be bonded in the first chamber,
a second holding portion that holds another of the two objects to be bonded in the first chamber,
a position measurement unit that measures relative positions of the two objects to be bonded, and
a holding portion drive unit that moves at least one of the first holding portion and the second holding portion relative to another.

5. The bonding system according to any one of claims 1 to 4, further comprising:
a first frame on which the bonder is placed; and
a second frame that is different from the first frame, the second frame on which the conveying device is placed,
wherein the first frame and the second frame are arranged apart from each other.

6. The bonding system according to claim 5, comprising:
a top plate on which a first chamber maintained in a depressurized state, a first holding portion that holds any one of the two objects to be bonded in the first chamber, a second holding portion that holds the other of the two objects to be bonded in the first chamber, and a position measurement unit that measures a relative position of the two objects to be bonded are arranged vertically upward; and
a plate support portion having an anti-vibration mechanism and movably supporting the top plate vertically upward.

7. The bonding system according to claim 6, wherein
the plate support portion is arranged vertically upward the first frame, and
the bonding system includes
a vibration detection unit that detects vibration transmitted to the top plate,
a plate drive unit that moves the top plate relative to the plate support portion, and
a vibration isolation control unit that controls the plate drive unit to move the top plate so as to offset the vibration based on the vibration detected by the vibration detection unit.

8. The bonding system according to claim 6, wherein
the first frame includes
the top plate,
the plate support portion,
a vibration detection unit that detects vibration transmitted to the top plate,
a plate drive unit that moves the top plate relative to the plate support portion, and
a vibration isolation control unit that controls the plate drive unit to move the top plate so as to offset the vibration based on the vibration detected by the vibration detection unit.

9. A bonding method for bonding two objects to be bonded, the bonding method comprising:
a conveying process in which a conveying device conveys, to the bonder, the two objects to be bonded in a state of being in contact with the bonder;
a detaching process in which the conveying device is brought into a state of being detached from the bonder and separated from the bonder;
a positioning process in which the bonder performs positioning of one of the two objects to be bonded with respect to another under reduced pressure in a state where the conveying device is separated from the bonder; and
a contact process in which the bonder brings the two objects to be bonded into contact under reduced pressure in a state where the conveying device is separated from the bonder.

10. The bonding method according to claim 9, wherein
the bonder includes a first chamber maintained in a depressurized state, a first gate provided in a part of the first chamber, and a first frame body provided to surround the first gate outside the first chamber,
the conveying device includes a second chamber maintained in a depressurized state, a second gate provided in a part of the second chamber, a second frame body provided to surround the second gate outside the second chamber, facing the first frame body, and arranged in a state of being separated from the first frame body, and a seal member having an annular shape, formed with a filling region filled with a fluid inside the seal member, arranged between the first frame body and the second frame body, the seal member being brought into a first state where the seal member expands by filling of a fluid in the filling region, is brought into close contact with the first frame body, and seals a region between the first frame body and the second frame body, and a second state where the seal member contracts by discharge of a fluid in the filling region, and is brought into a state of being separated from at least one of the first frame body and the second frame body, and
the bonding method further comprises, before the conveying process, a seal member abutting process of bringing the seal member from the second state into the first state by the conveying device filling a fluid to the filling region.

11. The bonding method according to claim 10, comprising:
a second gate opening process of bringing the second gate into an open state after the seal member abutting process; and
a first gate opening process of bringing the first gate into an open state after the second gate opening process.

12. The bonding method according to any one of claims 9 to 11, wherein
the conveying process, the detaching process, the positioning process, and the contact process are performed in a state where the bonder is installed on a first frame, and the conveying device is installed on a second frame different from the first frame and arranged apart from the first frame.

13. The bonding method according to claim 12, wherein
in the positioning process and the contact process, a top plate in which a first holding portion that holds any one of the two objects to be bonded included in the bonder, a second holding portion that holds another of the two objects to be bonded, a position measurement unit that measures relative positions of the two objects to be bonded, and a holding portion drive unit that moves at least one of the first holding portion and the second holding portion relative to another are arranged vertically upward, and a plate support portion having an anti-vibration mechanism and movably supporting the top plate vertically upward are used.

14. The bonding method according to claim 13, wherein
in the positioning process and the contact process, the plate support portion is arranged vertically upward the first frame, vibration transmitted to the top plate is detected, and the top plate is moved relative to the plate support portion based on the vibration having been detected.

15. The bonding method according to claim 13, wherein
in the positioning process and the contact process, vibration transmitted to the top plate is detected, and the top plate is moved relative to the plate support portion based on the vibration having been detected.
